# EUROPEAN PATENT APPLICATION

(11) **EP 4 848 501 A1**
(43) Date of publication of application: **02.12.2026**
(21) Application number: 25745161.7
(22) Date of filing: 22.01.2025
(51) Int. Cl.: H01S 5/026, G01S 7/484, H01S 5/042, H01S 5/42, H01S 5/183, H10H 20/00, H10H 20/813

(54) **LIGHT-EMITTING CHIP, LIGHT-EMITTING DEVICE, AND MEASUREMENT DEVICE**

(30) Priority: 24.01.2024 JP 2024009051; 23.12.2024 JP 2024226415
(71) Applicant: Fujifilm Business Innovation Corp., Tokyo 107-0052 (JP)
(72) Inventor: KONDO, Takashi, Ebina-shi, Kanagawa 243-0494 (JP); ONO, Seiji, Ebina-shi, Kanagawa 243-0494 (JP)
(74) Representative: Parker, Andrew James
(86) International application number: PCT/JP2025/001888
(87) International publication number: WO 2025/159120

(57) **Abstract**

A light-emitting device includes: a substrate; plural light-emitting elements disposed on the substrate; plural thyristors configured to enter an ON state so as to cause the corresponding light-emitting elements to emit light or to increase an amount of light emission of the corresponding light-emitting elements; a drive unit that is disposed on the substrate and individually drives the plural thyristors so as to bring each of the plural thyristors into an ON state; and a reference potential terminal that supplies a predetermined reference potential to the drive unit, a region in the drive unit connected to the reference potential terminal being electrically isolated from a side surface of the substrate.

## Description

### Technical Field

The present disclosure relates to a light-emitting chip, a light-emitting device, and a measurement apparatus.

### Background Art

PTL 1 discloses a light-emitting device including a semiconductor substrate, a light-emitting section, a signal line, and an oxide film. The light-emitting section is formed on the semiconductor substrate and includes multiple light-emitting elements that radiate light. The signal line is formed on the semiconductor substrate and transfers a signal to the light-emitting elements. The oxide film is formed along the signal line and between the signal line and the semiconductor substrate.

PTL 2 discloses a light-emitting section utilizing transistor coupling.

### Citation List

### Patent Literature

PTL 1: Japanese Unexamined Patent Application Publication No. 2023-42123
PTL 2: Japanese Unexamined Patent Application Publication No. 2023-112937

### Summary of Invention

### Technical Problem

In a light-emitting chip in which light-emitting elements and a drive unit that transfers a signal to the light-emitting elements are formed on a semiconductor substrate, a leakage current from a light-emitting element may flow to a terminal that supplies a reference potential to the drive unit via the semiconductor substrate, in particular, via a dicing surface on the outer periphery of the semiconductor substrate. In this case, the ON state of a light-emitting element that has already started emitting light is maintained, thereby causing a false turn-on.

Aspects of non-limiting embodiments of the present disclosure relate to a technology of suppressing the occurrence of a false turn-on more effectively than in the configuration in which a leakage current from a light-emitting element flows to a terminal that supplies a reference potential to a drive unit.

### Solution to Problem

(1) According to an aspect of the present disclosure, there is provided a light-emitting device including: a substrate; plural light-emitting elements disposed on the substrate; plural thyristors configured to enter an ON state so as to cause the corresponding light-emitting elements to emit light or to increase an amount of light emission of the corresponding light-emitting elements; a drive unit that is disposed on the substrate and individually drives the plural thyristors so as to bring each of the plural thyristors into an ON state; and a reference potential terminal that supplies a predetermined reference potential to the drive unit, a region in the drive unit connected to the reference potential terminal being electrically isolated from a side surface of the substrate.
(2) According to another aspect of the present disclosure, there is provided a light-emitting chip including: a semiconductor substrate; plural light-emitting elements and plural thyristors, the plural light-emitting elements being disposed on a surface of the semiconductor substrate, the plural thyristors being configured to enter an ON state so as to cause the corresponding light-emitting elements to emit light or to increase an amount of light emission of the corresponding light-emitting elements; a drive unit that is disposed on the surface of the semiconductor substrate and individually drives the plural thyristors so as to bring each of the plural thyristors into an ON state; a reference potential terminal that supplies a predetermined reference potential to the drive unit; and an isolator that suppresses a current flow between the reference potential terminal and the semiconductor substrate.
(3) In (2), the isolator may suppress extension of the drive unit to an outer periphery of the semiconductor substrate.
(4) In (2), the isolator may suppress formation of a current path via a side surface of the semiconductor substrate between the light-emitting elements and the reference potential terminal.
(5) In (2), the thyristors may be stacked on the light-emitting elements disposed on the surface of the semiconductor substrate, and the drive unit may be stacked on a structure equivalent to the light-emitting elements, the structure equivalent to the light-emitting elements being disposed on the semiconductor substrate.
(6) In (5), the light-emitting elements, the thyristors, and the drive unit may be constituted by a semiconductor multilayer body including plural stacked semiconductor layers having different conductivity types, and the isolator may be a groove provided in the semiconductor multilayer body or be a region in which insulating ions are implanted into the semiconductor multilayer body.
(7) In (6), the light-emitting elements and the structure equivalent to the light-emitting elements may each have a diode structure in which a p-type semiconductor layer, which serves as an anode, and an n-type semiconductor layer, which serves as a cathode, are stacked on each other, and the groove or the region in which the insulating ions are implanted may at least extend from the surface of the semiconductor substrate to one of the p-type semiconductor layer and the n-type semiconductor layer that is farther from the semiconductor substrate.
(8) In (6), the light-emitting elements may include a current confinement layer, the current confinement layer serving as an oxidized region in which a current does not readily flow, and the groove may have a depth reaching the current confinement layer.
(9) In (5), the structure equivalent to the light-emitting elements may have a diode structure in which a p-type semiconductor layer, which serves as an anode, and an n-type semiconductor layer, which serves as a cathode, are stacked on each other, and the reference potential may be applied to one of the p-type semiconductor layer and the n-type semiconductor layer that is farther from the semiconductor substrate.
(10) In (6), the groove or the region in which the insulating ions are implanted may be disposed to surround the drive unit.
(11) In (2), the drive unit may sequentially propagate the ON state among the plural thyristors.
(12) According to another aspect of the present disclosure, there is provided a light-emitting chip including: a semiconductor substrate; plural light-emitting elements and plural thyristors, the plural light-emitting elements being disposed on a surface of the semiconductor substrate, the plural thyristors being stacked on the plural light-emitting elements, the plural thyristors being configured to enter an ON state so as to cause the corresponding light-emitting elements to emit light or to increase an amount of light emission of the corresponding light-emitting elements; a reference potential terminal that is disposed on a structure equivalent to the light-emitting elements, a predetermined reference potential being supplied to the reference potential terminal; and an isolator that suppresses formation of a current path via a side surface of the semiconductor substrate between the light-emitting elements and the reference potential terminal.
(13) According to another aspect of the present disclosure, there is provided a light-emitting device including: the light-emitting chip according to one of (2) to (12); and a driver that is set at one end to a ground potential and is connected at another end to the semiconductor substrate of the light-emitting chip and that is configured to enter an ON state at a predetermined timing so as to cause a light-emission current to flow to the light-emitting element.
(14) According to another aspect of the present disclosure, there is provided a measurement apparatus including: the light-emitting device according to (13); and an acquisition unit that acquires information on a subject based on light emitted from the light-emitting device and reflected by the subject.

### Advantageous Effects of Invention

According to (1), (2), and (12), a false turn-on is less likely to occur than in the configuration in which a leakage current from the light-emitting element may flow to the reference potential terminal of the drive unit.

According to (3), the side surface of the light-emitting chip becomes less vulnerable to dicing-induced damage than in the configuration in which the drive unit extends to the outer periphery of the semiconductor substrate.

According to (4), dicing-induced damage can be accommodated.

According to (5), the light-emitting elements of the light-emitting chip can be aligned with higher density than in the configuration in which the thyristors are not stacked on the light-emitting elements.

According to (6), the drive unit and the dicing surface can be electrically isolated from each other.

According to (7), the effect of electrically isolating the drive unit and the dicing surface from each other can be enhanced.

According to (8), the isolator can be formed in the same process as in the formation of the current blocking region.

According to (9), electrical isolation can be achieved by the pn junction.

According to (10), the reference potential and the substrate potential can be isolated from each other more effectively than in the configuration in which the groove or the region in which the insulating ions are implanted does not surround the drive unit.

According to (11), ON/OFF control for the light-emitting elements is facilitated compared with the configuration in which the ON state does not sequentially propagate among the thyristors.

According to (13), the light-emitting elements can be driven at higher speed than when the high-side drive configuration is employed.

According to (14), a measurement apparatus that can perform three-dimensional measurement can be provided.

### Brief Description of Drawings

[Fig. 1] Fig. 1 is a schematic diagram illustrating an example of a measurement apparatus according to a first exemplary embodiment.
[Fig. 2] Fig. 2 is an equivalent circuit diagram of a light source device according to the first exemplary embodiment.
[Fig. 3] Fig. 3A is a plan view illustrating an example of the layout of a light-emitting chip according to the first exemplary embodiment, and Fig. 3B is a sectional view taken along line IIIB-IIIB in Fig. 3A.
[Fig. 4] Fig. 4 is an enlarged sectional view of an example of an island in which a VCSEL and a setting thyristor are stacked on each other.
[Fig. 5] Fig. 5A is a sectional view of a light-emitting chip without a groove and illustrates a leakage current in the light source device of the first exemplary embodiment, and Fig. 5B is a sectional view of a light-emitting chip with a groove and illustrates a leakage current that would occur in the light source device of the first exemplary embodiment.
[Fig. 6] Fig. 6A is a plan view illustrating an example of the layout of a light-emitting chip according to a modified example of the first exemplary embodiment, and Fig. 6B is a sectional view taken along line VIB-VIB in Fig. 6A.
[Fig. 7] Fig. 7 is an equivalent circuit diagram of a light source device according to a second exemplary embodiment.
[Fig. 8] Fig. 8 is an equivalent circuit diagram of a light source device according to a third exemplary embodiment.
[Fig. 9] Fig. 9A is an equivalent circuit diagram illustrating an operation of a light-emitting chip according to the third exemplary embodiment, and Fig. 9B is a partial sectional view illustrating a transfer thyristor and a coupling transistor shown in Fig. 9A.
[Fig. 10] Fig. 10A is a plan view illustrating an example of the layout of the light-emitting chip according to the third exemplary embodiment, and Fig. 10B is a sectional view taken along line XB-XB in Fig. 10A.
[Fig. 11] Fig. 11 is an equivalent circuit diagram of a light source device according to a fourth exemplary embodiment.
[Fig. 12] Fig. 12A is a sectional view of a light-emitting chip without a groove and illustrates a leakage current in the light source device of the fourth exemplary embodiment, and Fig. 12B is a sectional view of a light-emitting chip with a groove and illustrates a leakage current that would occur in the light source device of the fourth exemplary embodiment.

### Description of Embodiments

Exemplary embodiments of the disclosure will be described below in detail with reference to the accompanying drawings.

In the exemplary embodiments, an application example will be described in which a light source device 1, which is an example of a light-emitting device, including a light-emitting chip 10 is used in a measurement apparatus that measures a three-dimensional configuration (hereinafter called a 3D configuration) of a subject.

### [First Exemplary Embodiment]

### (Measurement Apparatus 100)

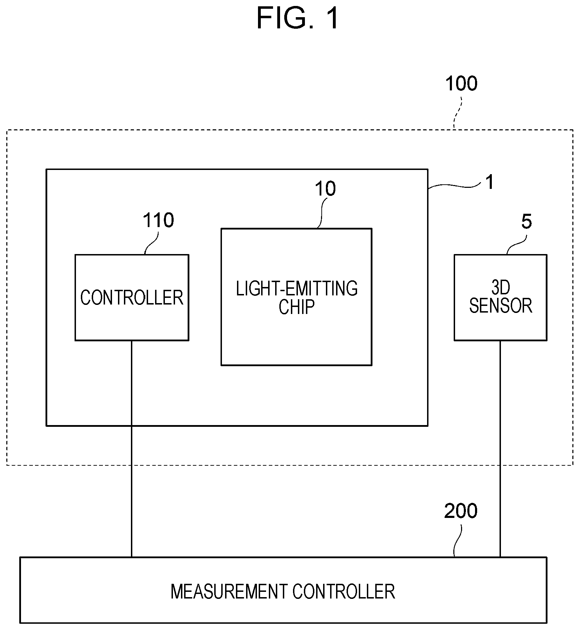

Fig. 1 is a schematic diagram illustrating an example of a measurement apparatus 100 according to a first exemplary embodiment.

The measurement apparatus 100 of the first exemplary embodiment measures a 3D configuration of a subject. More specifically, the measurement apparatus 100 measures a 3D configuration of a subject based on a ToF (Time of Flight) method using the time-of-flight of light. The measurement apparatus 100 includes a light source device 1 and a three-dimensional sensor (hereinafter called a 3D sensor) 5. The light source device 1 includes a light-emitting chip 10 and a controller 110. According to the ToF method, the time from when light is emitted from the light source device 1 until when the 3D sensor 5 receives light reflected by a subject is measured. Based on the time obtained by the 3D sensor 5, the distance to the subject is calculated and the 3D configuration of the subject is specified. Measuring a 3D configuration may also be called three-dimensional measurement, 3D measurement, and 3D sensing.

The light source device 1 emits light toward a subject. The 3D sensor 5 receives light reflected by and returned from the subject (reflected light). The 3D sensor 5 outputs information on the distance to the subject (distance information) obtained based on the ToF-measured time from when light is emitted until the reflected light is received. The measurement apparatus 100 may include a measurement controller 200. The measurement controller 200 is constituted by a CPU, a ROM, a RAM, and other elements, and specifies the 3D configuration of a subject based on the distance information obtained from the 3D sensor 5. The measurement controller 200 is an example of an acquisition unit.

The measurement apparatus 100 may be used for recognizing a subject from the specified 3D configuration. For example, the measurement apparatus 100 may be installed in a mobile information processing device and be used for recognizing the face of a user who is accessing the mobile information processing device. That is, the measurement apparatus 100 obtains the 3D configuration of the face of a user having accessed the mobile information processing device, determines whether the user is authorized to access the device, and permits the user to use the device only when the user is an authorized user.

The measurement apparatus 100 may also be used for a case in which the 3D configuration of a subject is continuously measured, such as in AR (Augmented Reality).

The above-described subject to be measured is an example of a subject, and the measurement apparatus 100 is an example of a measurement apparatus.

### (Light Source Device 1)

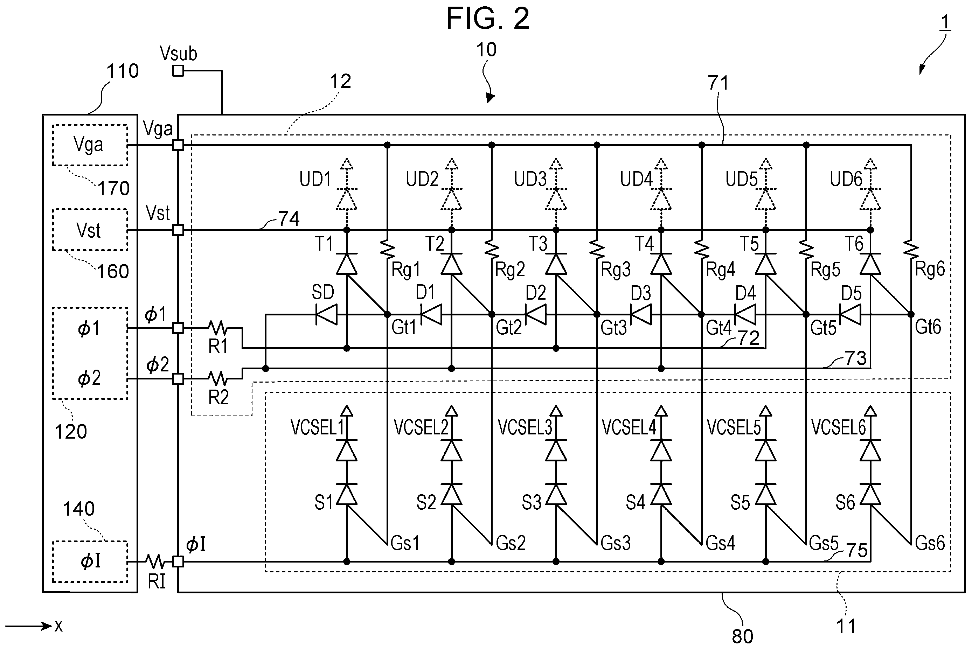

Fig. 2 is an equivalent circuit diagram of the light source device 1 according to the first exemplary embodiment. In Fig. 2, the rightward direction in the drawing is taken as the +x direction.

The light source device 1 shown in Fig. 2 includes the light-emitting chip 10 and the controller 110.

### (Controller 110)

The controller 110 includes a transfer signal generator 120, a light-emission signal generator 140, a reference potential supplier 160, and a power supply potential supplier 170.

The transfer signal generator 120 generates a first transfer signal φ1 and a second transfer signal φ2 for sequentially propagating the ON state among multiple transfer thyristors T in a transfer section 12, which will be discussed later. The light-emission signal generator 140 generates a light-emission signal φI for supplying a current to cause VCSELs, which will be discussed later, to turn ON (emit light). The reference potential supplier 160 supplies a reference potential Vst for the transfer section 12. The power supply potential supplier 170 supplies a power supply potential Vga. The current that causes the VCSEL to turn ON (emit light) may also be referred to as a light-emission current.

### (Light-Emitting Chip 10)

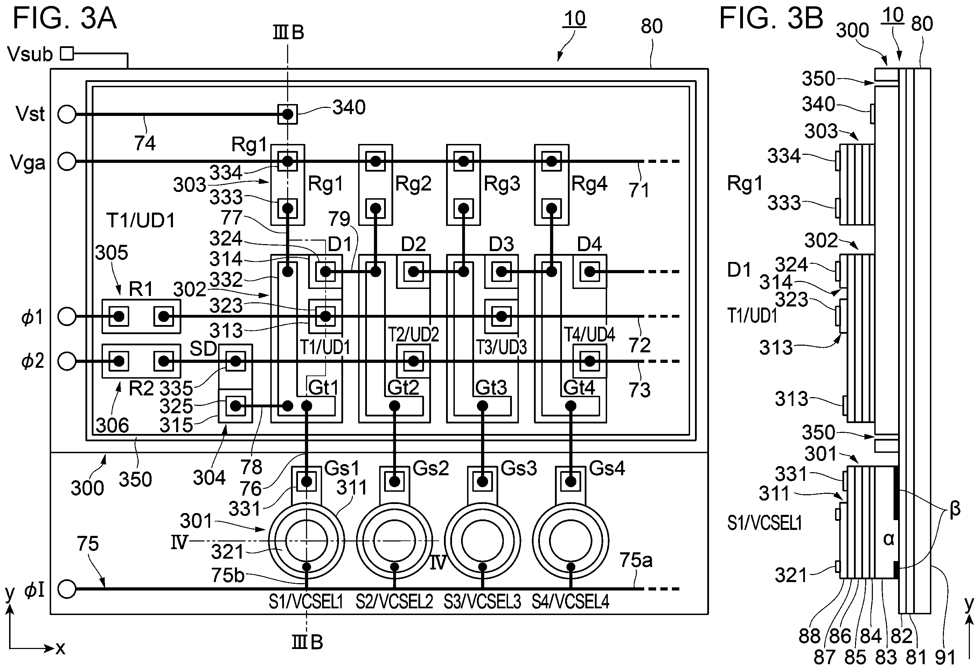

The light-emitting chip 10 includes a light-emitting section 11 and the transfer section 12. The light-emitting chip 10 includes a φ1 terminal, a φ2 terminal, a Vga terminal, a φI terminal, and a Vst terminal. The light-emitting chip 10 also includes a Vsub terminal. The Vsub terminal is a back-side electrode 91 provided on the back side of a substrate 80 (see Fig. 3B, which will be described later). In Fig. 2, the terminals of elements connected to the substrate 80 (that is, the Vsub terminal) are represented by triangle symbols.

The light-emitting section 11 includes VCSELs (Vertical Cavity Surface Emitting Lasers). Hereinafter, a vertical cavity surface emitting laser will be simply referred to as a VCSEL. In the example in Fig. 2, six VCSEL1 through VCSEL6 (simply called the VCSELs if it is not necessary to distinguish them from each other) are provided. The light-emitting section 11 also includes six setting thyristors S1 through S6 (simply called the setting thyristors S if it is not necessary to distinguish them from each other). The anode of the VCSEL and the cathode of the setting thyristor S are connected to each other. That is, the setting thyristor and the VCSEL having the same number are connected in series with each other. As shown in Fig. 3B, which will be described later, the setting thyristor S is stacked on the corresponding VCSEL formed on the substrate 80. The setting thyristor S may also be simply called the thyristor.

In the first exemplary embodiment, each VCSEL is an example of a light-emitting element, and each setting thyristor S is an example of a thyristor.

The transfer section 12 includes six transfer thyristors T1 through T6 (simply called the transfer thyristors T if it is not necessary to distinguish them from each other) and six underlying diodes UD1 through UD6 (simply called the underlying diodes UD if it is not necessary to distinguish them from each other). Among the transfer thyristors T1 through T6 and the underlying diodes UD1 through UD6, the transfer thyristor T and the underlying diode UD having the same number are connected in series with each other. As shown in Fig. 3B, the transfer thyristor T is stacked on the corresponding underlying diode UD formed on the substrate 80. The underlying diodes UD1 through UD6 are not separated from each other but are integrally formed, which will be discussed later. The underlying diodes UD1 through UD6 do not function as active diodes. In Fig. 2, the underlying diodes UD1 through UD6 are indicated by the dotted lines.

In the transfer section 12, the transfer thyristors T1 through T6 are grouped into pairs in numerical order and coupling diodes D1 through D5 (simply called the coupling diodes D if it is not necessary to distinguish them from each other) are disposed between adjacent transfer thyristors T of the respective pairs.

The transfer section 12 also includes power supply line resistors Rg1 through Rg6 (simply called the power supply line resistors Rg if it is not necessary to distinguish them from each other).

The transfer section 12 also includes a start diode SD.

The transfer section 12 also includes current limiting resistors R1 and R2. The current limiting resistor R1 prevents an excessive current from flowing through the first transfer signal line 72 through which a first transfer signal φ1 is transmitted, while the current limiting resistor R2 prevents an excessive current from flowing through the second transfer signal line 73 through which a second transfer signal φ2 is transmitted. The first and second transfer signal lines 72 and 73 will be discussed later.

In the light-emitting chip 10, the VCSEL1 through VCSEL6 and the setting thyristors S1 through S6 of the light-emitting section 11 and the transfer thyristors T1 through T6 of the transfer section 12 are arranged in numerical order from one side (-x-direction side and the left side in Fig. 2) to the other side (+x-direction side and the right side in Fig. 2). In the light-emitting chip 10, the underlying diodes UD1 through UD6, coupling diodes D1 through D5, and power supply line resistors Rg1 through Rg6 are also arranged in numerical order from one side (-x-direction side and the left side in Fig. 2) to the other side (+x-direction side and the right side in Fig. 2).

In the first exemplary embodiment, the numbers of VCSELs and setting thyristors S of the light-emitting section 11 and the numbers of transfer thyristors T, underlying diodes UD, and power supply line resistors Rg of the transfer section 12 are all six. The number of coupling diodes D is five, which is one less than the number of transfer thyristors T. The above-described numbers of VCSELs, setting thyristors S, transfer thyristors T, underlying diodes UD, power supply line resistors Rg, and coupling diodes D are only examples, and predetermined numbers of the above-described elements may be set. The number of transfer thyristors T may be greater than that of VCSELs.

Each of the VCSELs, underlying diodes UD, coupling diodes D, and start diode SD is a two-terminal semiconductor element having an anode terminal (anode) and a cathode terminal (cathode). Each of the thyristors (setting thyristors S and the transfer thyristors T) is a three-terminal semiconductor element having an anode terminal (anode), a gate terminal (gate), and a cathode terminal (cathode). Hereinafter, the anode terminal, gate terminal, and cathode terminal may be simply called an anode, a gate, and a cathode, respectively.

The light-emitting chip 10 in the first exemplary embodiment is formed of a III-V compound semiconductor, such as GaAs, AlGaAs, or AlAs. The light-emitting chip 10 is a monolithic semiconductor circuit constituted by a semiconductor multilayer body obtained by growing multiple semiconductor layers having different conductivity types on the semiconductor substrate 80 by epitaxial growth. The light-emitting chip 10 can be obtained by dicing a semiconductor wafer on which multiple light-emitting chips 10 are collectively formed.

Electrical connection of the elements of the light-emitting chip 10 will now be described below.

The cathodes of the VCSELs and the underlying diodes UD are connected to the substrate 80 (cathode common). A substrate potential Vsub is supplied to these cathodes via the back-side electrode 91 (see Fig. 3B), which is the Vsub terminal, disposed on the back side of the substrate 80.

The anode of each VCSEL is connected to the cathode of the corresponding setting thyristor S.

The anode of each underlying diode UD is connected to the cathode of the corresponding transfer thyristor T. The cathode of the transfer thyristor T (sharing the same node as the anode of the underlying diode UD) is connected to a reference potential line 74. The reference potential line 74 is connected to the Vst terminal. The reference potential Vst is supplied from the reference potential supplier 160 to the Vst terminal. The Vst terminal may be a reference potential terminal 340 shown in Figs. 3A and 3B, which will be discussed later. The reference potential terminal 340 is a terminal for supplying a reference potential to the transfer section 12.

In accordance with the arrangement of the transfer thyristors T, the anodes of the odd-numbered transfer thyristors T1, T3, and T5 are connected to the first transfer signal line 72. The first transfer signal line 72 is connected to the φ1 terminal via the current limiting resistor R1. The first transfer signal φ1 is supplied from the transfer signal generator 120 of the controller 110 to the φ1 terminal.

In accordance with the arrangement of the transfer thyristors T, the anodes of the even-numbered transfer thyristors T2, T4, and T6 are connected to the second transfer signal line 73. The second transfer signal line 73 is connected to the φ2 terminal via the current limiting resistor R2. The second transfer signal φ2 is supplied from the transfer signal generator 120 of the controller 110 to the φ2 terminal.

The anodes of the setting thyristors S are connected to a light-emission signal line 75. The light-emission signal line 75 is connected to the φI terminal. The light-emission signal φI is supplied from the light-emission signal generator 140 of the controller 110 to the φI terminal via a current limiting resistor RI disposed outside the light-emitting chip 10. The light-emission signal φI serves to supply a light-emission current to the VCSEL.

Gates Gt1 through Gt6 (simply called the gates Gt if it is not necessary to distinguish them from each other) of the transfer thyristors T1 through T6 are respectively connected to gates Gs1 through Gs6 (simply called the gates Gs if it is not necessary to distinguish them from each other) of the setting thyristors S1 through S6 based on a one-to-one correspondence. Accordingly, among the gates Gt1 through Gt6 and the gates Gs1 through Gs6, the gate Gt and the gate Gs having the same number are electrically at the same potential. For example, the gate Gt1 (gate Gs1) indicates that the gates Gt1 and Gs1 are at the same potential.

The gates Gt1 through Gt6 of the transfer thyristors T1 through T6 are grouped into pairs in numerical order, and the coupling diodes D1 through D5 are connected between adjacent gates Gt of the respective pairs. That is, the coupling diodes D1 through D5 are directly connected so as to be sandwiched between adjacent gates Gt of the respective pairs. The coupling diode D1 is connected in the direction in which a current flows from the gate Gt2 to the gate Gt1. The other coupling diodes D2 through D5 are connected in a similar manner.

The gates Gt (gates Gs) of the transfer thyristors T are connected to a power supply line 71 via the power supply line resistors Rg provided for the respective transfer thyristors T. The power supply line 71 is connected to the Vga terminal. The power supply potential Vga is supplied from the power supply potential supplier 170 of the controller 110 to the Vga terminal.

The gate Gt1 of the transfer thyristor T is connected to the anode of the start diode SD. The cathode of the start diode SD is connected to the second transfer signal line 73.

Fig. 3A is a plan view illustrating an example of the layout of the light-emitting chip 10 according to the first exemplary embodiment. Fig. 3B is a sectional view taken along line IIIB-IIIB in Fig. 3A.

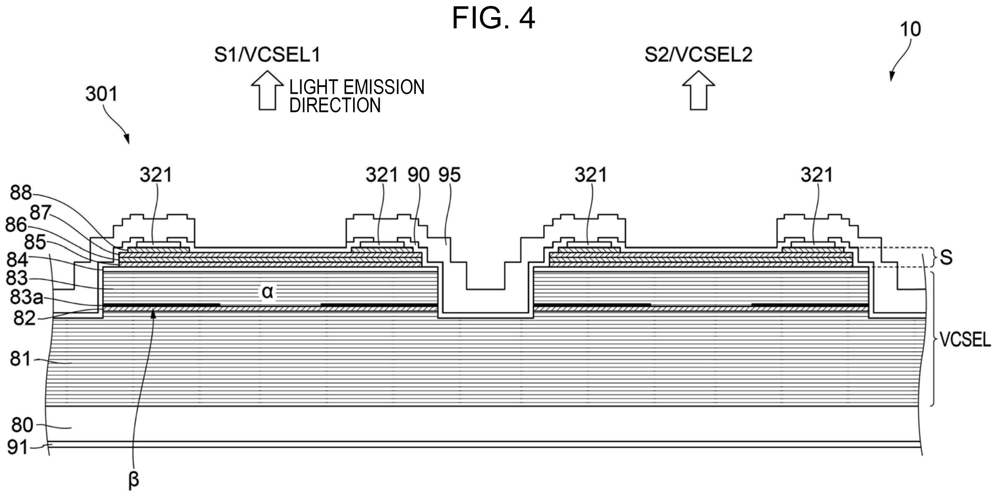

In Figs. 3A and 3B, a protection layer (protection layer 90 in Fig. 4) and a light-shielding layer (light-shielding layer 95 in Fig. 4), which will be discussed later, are not shown. In Fig. 3B, the interconnection lines illustrated in Fig. 3A are not shown.

In Fig. 3A, among the VCSEL1 through VCSEL6 , setting thyristors S1 through S6, and transfer thyristors T1 through T6 shown in Fig. 2, the VCSEL1 through VCSEL4, setting thyristors S1 through S4, and transfer thyristors T1 through T4 are shown. Among the underlying diodes UD1 through UD6, coupling diodes D1 through D5, and power supply line resistors Rg1 through Rg6, the underlying diodes UD1 through UD4, coupling diodes D1 through D4, and power supply line resistors Rg1 through Rg4 are shown.

In Fig. 3B, a cross section of the setting thyristor S1, VCSEL1, transfer thyristor T1, underlying diode UD1, coupling diode D1, and power supply line resistor Rg1 shown in Fig. 2 is illustrated.

The cross-sectional structure of the light-emitting chip 10 will first be discussed below with reference to Fig. 3B.

In the light-emitting chip 10, an n-type cathode layer 81, a light-emitting layer 82, and a p-type anode layer 83, which form the VCSELs and the underlying diodes UD, are sequentially disposed on an n-type substrate 80 (substrate 80). The n-type cathode layer 81 and the p-type anode layer 83 are constituted by DBR (Distributed Bragg Reflector) layers (hereinafter simply called the DBR layers) obtained by depositing semiconductor layers having different refractive indexes on each other. Accordingly, hereinafter, the n-type cathode layer 81 will be called the n-cathode (DBR) layer 81, while the p-type anode layer 83 will be called the p-anode (DBR) layer 83.

In the light-emitting chip 10, a tunnel junction (tunnel diode) layer 84 is disposed on the p-anode (DBR) layer 83.

In the light-emitting chip 10, an n-type cathode layer (n-cathode layer) 85, a p-type gate layer (p-gate layer) 86, an n-type gate layer (n-gate layer) 87, and a p-type anode layer (p-anode layer) 88, which form the setting thyristors S, transfer thyristors T, coupling diodes D, and power supply line resistors Rg, are sequentially disposed on the tunnel junction layer 84.

In the following, the above parenthetical notations are used, and the same applies throughout.

As illustrated in Figs. 3A and 3B, elements, such as the VCSELs, underlying diodes UD, setting thyristors S, transfer thyristors T, and coupling diodes D, are formed of multiple islands obtained by removing part of each of the above-described layers by etching. The islands may also be called mesas, and etching to form islands (mesas) may also be called mesa etching.

In the light-emitting chip 10, these islands are connected to lines, such as the power supply line 71, first transfer signal line 72, second transfer signal line 73, reference potential line 74, and light-emission signal line 75, via through-holes (indicated by the black dots in Fig. 3A) provided in the protection layer (protection layer 90 in Fig. 4, which will be discussed later). In the following description, an explanation of the protection layer and the through-holes are not given.

As illustrated in Fig. 3B, the back-side electrode 91, which serves as the Vsub terminal, is provided on the back side of the substrate 80.

The n-cathode (DBR) layer 81 and the p-anode (DBR) layer 83 are designated in accordance with the functions of the VCSELs and the underlying diodes UD. That is, the n-cathode (DBR) layer 81 functions as the cathode, while the p-anode (DBR) layer 83 functions as the anode.

The n-cathode layer 85, p-gate layer 86, n-gate layer 87, and p-anode layer 88 are designated in accordance with the functions of the setting thyristors S and the transfer thyristors T. That is, the n-cathode layer 85 serves as the cathode, the p-gate layer 86 and the n-gate layer 87 serve as the gate, and the p-anode layer 88 serves as the anode.

When the above-described layers form the coupling diodes D and the power supply line resistors Rg, they have different functions, which will be discussed later.

Not all the islands in the light-emitting chip 10 have the entirety of each of the n-cathode (DBR) layer 81, light-emitting layer 82, p-anode (DBR) layer 83, tunnel junction layer 84, n-cathode layer 85, p-gate layer 86, n-gate layer 87, and p-anode layer 88. For example, islands 301 and 302, which will be discussed later, do not have part of the p-anode layer 88. This will be explained later.

The substrate 80, back-side electrode 91, and n-cathode (DBR) layer 81 are at the same potential and may thus be collectively called the substrate 80. In the specification, the substrate 80 may include the back-side electrode 91 and the n-cathode (DBR) layer 81.

An example of the layout of the light-emitting chip 10 will be described below with reference to Fig. 3A.

The island 301 includes the VCSEL1 and the setting thyristor S1. The island 302 includes the transfer thyristor T1 and the coupling diode D1. An island 303 includes the power supply line resistor Rg1. An island 304 includes the start diode SD. An island 305 includes the current limiting resistor R1. An island 306 includes the current limiting resistor R2.

In the light-emitting chip 10, multiple sets of islands similar to the islands 301, 302, and 303 are formed in parallel with each other. These islands include the VCSEL2 through VCSEL6, setting thyristors S2 through S6, underlying diodes UD2 through UD6, transfer thyristors T2 through T6, coupling diodes D2 through D5, and other elements as in the islands 301, 302, and 303.

The islands 302 through 306 and islands similar to the islands 302 and 303 are disposed on an island 300.

The islands 300 through 306 will be described below in detail with reference to Figs. 3A and 3B.

As shown in Fig. 3B, the island 301 is separated from the other islands by removing the p-anode layer 88, n-gate layer 87, p-gate layer 86, n-cathode layer 85, tunnel junction layer 84, p-anode (DBR) layer 83, and light-emitting layer 82 in the thickness direction by mesa etching. It is sufficient that the light-emitting layer 82 be partially removed in the thickness direction. The n-cathode (DBR) layer 81 may be entirely or partially removed.

The VCSEL1 formed in the island 301 is constituted by the n-cathode (DBR) layer 81, light-emitting layer 82, and p-anode (DBR) layer 83. The setting thyristor S is constituted by the stacked n-cathode layer 85, p-gate layer 86, n-gate layer 87, and p-anode layer 88 on the tunnel junction layer 84, which is stacked on the p-anode (DBR) layer 83 of the VCSEL1.

The p-anode (DBR) layer 83 of the VCSEL includes a current confinement layer (current confinement layer 83a in Fig. 4, which will be discussed later), which confines a current, as indicated by the solid black portions in Fig. 3B. The current confinement layer serves as a current blocking region β in which a current does not readily flow because of the oxidization of the exposed portion of a semiconductor layer constituting the p-anode (DBR) layer 83 by mesa etching. In contrast, the central portion of the semiconductor layer constituting the p-anode (DBR) layer 83, which is not exposed by mesa etching, forms a current passing region α in which a current readily flows.

The current blocking region β reduces power which would be consumed for non-radiative recombination, thereby enhancing power saving and light extraction efficiency. The light extraction efficiency is represented by the amount of light that can be extracted per unit power.

To expose the current confinement layer, the depth of the semiconductor layers to be removed by mesa etching to separate the island 301 may be such that part of the light-emitting layer 82 in the thickness direction be removed.

In the island 301, the portion of the setting thyristor S1 (p-anode layer 88, n-gate layer 87, p-gate layer 86, n-cathode layer 85, tunnel junction layer 84) from which light is output may be removed. In this case, the setting thyristor S1 is formed in a cylindrical shape. With this arrangement, light output from the VCSEL1 is less likely to be absorbed in the setting thyristor S1 and to reduce the amount of light.

Referring back to Fig. 3B, the island 301 will be described. A p-type ohmic electrode (p-ohmic electrode) 321 provided on a region 311 of the p-anode layer 88 is used as the anode terminal of the setting thyristor S1. An n-type ohmic electrode (n-ohmic electrode) 331 provided on the n-gate layer 87 exposed by removing the p-anode layer 88 is used as the terminal of the gate Gs1 of the setting thyristor S1.

The island 300 is separated from the island 301 and islands similar to the island 301 by removing the p-anode layer 88, n-gate layer 87, p-gate layer 86, n-cathode layer 85, tunnel junction layer 84, p-anode (DBR) layer 83, and light-emitting layer 82 in the thickness direction by mesa etching. The islands 302 through 306 and islands similar to the islands 302 and 303 are disposed in the island 300. The islands 302 through 306 will be explained below.

The islands 302 through 306 in the island 300 are separated from each other by removing the p-anode layer 88, n-gate layer 87, p-gate layer 86, n-cathode layer 85, and tunnel junction layer 84 by mesa etching. In the island 300, the p-anode (DBR) layer 83, light-emitting layer 82, and n-cathode (DBR) layer 81 are left under the islands 302 through 306. The p-anode (DBR) layer 83, light-emitting layer 82, and n-cathode (DBR) layer 81 left in the island 300 form the underlying diodes UD1 through UD6. That is, the underlying diodes UD1 through UD6 are not separated but are integrated. Similarly to the VCSELs, which are light-emitting elements, the underlying diodes UD1 through UD6 are constituted by the n-cathode (DBR) layer 81, light-emitting layer 82, and p-anode (DBR) layer 83. Hence, the underlying diodes UD form a structure in the first exemplary embodiment and are equivalent to the light-emitting elements. The VCSEL and the underlying diode UD each have a pn-junction diode structure.

When performing mesa etching to separate the islands 302 through 306, the n-cathode layer 85 and the tunnel junction layer 84 may not necessarily be removed. The p-anode (DBR) layer 83 and the n-cathode layer 85 are stacked on each other with the tunnel junction layer 84 therebetween and are thus at the same potential. The tunnel junction layer 84 and the n-cathode layer 85 may be left without removing them. In the following description, it is assumed that the p-anode (DBR) layer 83 is exposed.

The transfer thyristor T1 disposed in the island 302 is constituted by the n-cathode layer 85, p-gate layer 86, n-gate layer 87, and p-anode layer 88, similarly to the setting thyristor S1.

A p-ohmic electrode 323 disposed on a region 313 of the p-anode layer 88 is used as the anode terminal. An n-ohmic electrode 332 disposed on the n-gate layer 87 exposed by removing the p-anode layer 88 is used as the terminal of the gate Gt1.

The coupling diode D1 disposed in the island 302 is constituted by the n-gate layer 87 and the p-anode layer 88. A p-ohmic electrode 324 disposed on a region 314 of the p-anode layer 88 is used as the anode terminal. The n-ohmic electrode 332 disposed on the n-gate layer 87 exposed by removing the p-anode layer 88 is used as the cathode terminal. The cathode terminal of the coupling diode D is the same as the terminal of the gate Gt1.

The power supply line resistor Rg1 disposed in the island 303 is constituted by the p-anode layer 88. That is, the portion of the p-anode layer 88 between the p-ohmic electrodes 333 and 334 is used as the power supply line resistor Rg1.

The start diode SD disposed in the island 304 is constituted by the n-gate layer 87 and the p-anode layer 88, though it is not shown in Fig. 3B. That is, a p-ohmic electrode 325 disposed on a region 315 of the p-anode layer 88 is used as the anode terminal of the start diode SD (see Fig. 3A). An n-ohmic electrode 335 disposed on the n-gate layer 87 exposed by removing the p-anode layer 88 is used as the cathode terminal of the start diode SD (see Fig. 3A).

The current limiting resistor R1 in the island 305 and the current limiting resistor R2 in the island 306 are provided in a manner similar to the power supply line resistor Rg1 in the island 303. Each of the current limiting resistors R1 and R2 is formed by a portion of the p-anode layer 88 between two p-ohmic electrodes (see Fig. 3A).

The transfer section 12 is constituted by the island 302 in which the transfer thyristor T1 and the coupling diode D1 are disposed, the island 303 in which the power supply line resistor Rg1 is disposed, islands similar to the islands 302 and 303, the island 304 in which the start diode SD is disposed, the island 305 in which the current limiting resistor R1 is disposed, and the island 306 in which the current limiting resistor R2 is disposed. The transfer section 12 is provided in the island 300.

In the island 300, a groove 350 is disposed to surround the islands 302 through 306 and islands similar to the islands 302 and 303. The groove 350 is formed in the exposed portion of the p-anode (DBR) layer 83 in the island 300 by removing this portion by mesa etching. To form the groove 350, at least the p-anode (DBR) layer 83 is removed. The p-anode (DBR) layer 83 may be removed until the light-emitting layer 82 under the p-anode (DBR) layer 83 or until the n-cathode (DBR) layer 81. That is, the groove 350 has the same depth as the depth of mesa etching to separate the island 301. Accordingly, when separating the island 301 by mesa etching, the groove 350 can be formed. That is, mesa etching to separate the island 301 and mesa etching to form the groove 350 can be performed in the same process. This can eliminate the need to provide an additional step of forming the groove 350 by mesa etching. The groove 350 extends at least from the surface of the substrate 80 to the p-type semiconductor layer (p-anode (DBR) layer 83, for example) or the n-type semiconductor layer (n-cathode (DBR) layer 81, for example) that is farther from the substrate 80 (p-anode (DBR) layer 83, for example). As a result, electrical isolation can be ensured by the pn junction between the p-type semiconductor layer and the n-type semiconductor layer that form the diode structure.

The groove 350 will be discussed later.

The connection relationship between the individual elements will be described below with reference to Fig. 3A.

The light-emission signal line 75 includes a trunk portion 75a and multiple branch portions 75b. The trunk portion 75a is disposed to extend in the row direction of the setting thyristors S and the VCSELs. The branch portions 75b each branch off from the trunk portion 75a, and one branch portion 75b is connected to the corresponding p-ohmic electrode 321, which also serves as the anode terminal of the setting thyristor S1 disposed in the island 301. The other branch portions 75b are also connected to the corresponding p-ohmic electrodes 321, which are the anode terminals of the other setting thyristors S.

The light-emission signal line 75 is connected to the φI terminal.

The first transfer signal line 72 is connected to the p-ohmic electrode 323, which serves as the anode terminal of the transfer thyristor T1 disposed in the island 302. The first transfer signal line 72 is also connected to the anode terminals of the other odd-numbered transfer thyristors T disposed in the corresponding islands similar to the island 302. The first transfer signal line 72 is connected to the φ1 terminal via the current limiting resistor R1 disposed in the island 305.

The second transfer signal line 73 is connected to p-ohmic electrodes, which serve as the anode terminals of the even-numbered transfer thyristors T disposed in the corresponding islands. The second transfer signal line 73 is connected to the φ2 terminal via the current limiting resistor R2 disposed in the island 306.

The power supply line 71 is connected to the p-ohmic electrode 334, which is one terminal of the power supply line resistor Rg1, disposed in the island 303. The power supply line 71 is also connected to one terminal of each of the other power supply line resistors Rg. The power supply line 71 is connected to the Vga terminal.

The n-ohmic electrode 331 (gate terminal Gs1) of the setting thyristor S1 disposed in the island 301 is connected via an interconnection line 76 to the n-ohmic electrode 332 (gate terminal Gt1) in the island 302.

The n-ohmic electrode 332 (gate terminal Gt1) is connected via an interconnection line 77 to the p-ohmic electrode 333 (the other terminal of the power supply line resistor Rg1) disposed in the island 303.

The p-ohmic electrode 324 (anode terminal of the coupling diode D1) disposed in the island 302 is connected via an interconnection line 79 to an n-ohmic electrode, which is the gate terminal Gt2 of the adjacent transfer thyristor T2.

The connection relationships between other elements, such as the other VCSELs, the other setting thyristors S, the other transfer thyristors T, and the other coupling diodes D, are similar to those described above, though an explanation thereof is omitted here.

The n-ohmic electrode 332 (gate terminal Gt1) in the island 302 is connected via an interconnection line 78 to the p-ohmic electrode 325 (cathode terminal of the start diode SD) in the island 304. The n-ohmic electrode 335 (cathode terminal of the start diode SD) is connected to the second transfer signal line 73.

In the island 300, the p-ohmic electrode 340 is disposed on the p-anode (DBR) layer 83 surrounded by the groove 350. The p-ohmic electrode 340 is connected to the reference potential line 74. The reference potential line 74 is connected to the Vst terminal to which the reference potential Vst is supplied. Instead of providing the reference potential line 74 and the Vst terminal, the p-ohmic electrode 340 may be used as the Vst terminal or the reference potential line 74. Hereinafter, the Vst terminal will be referred to as the reference potential terminal 340. The reference potential terminal 340 is an example of a reference potential terminal. The p-anode (DBR) layer 83 on which the reference potential terminal 340 is disposed is continuously provided under the transfer section 12. Because of the reference potential terminal 340, the p-anode (DBR) layer 83 is set at a potential that serves as a reference potential (reference potential Vst) for the operation of the transfer section 12. The transfer section 12 is disposed in a region surrounded by the groove 350 and is operated based on the reference potential Vst supplied to the reference potential terminal 340.

When performing mesa etching for the islands 302 through 306, if the n-cathode layer 85 and the tunnel junction layer 84 are not removed, the p-ohmic electrode 340 is replaced by an n-ohmic electrode.

### (Multilayer Structure of Setting Thyristor S and VCSEL)

Fig. 4 is an enlarged sectional view of an example of the island 301 in which the VCSEL and the setting thyristor S are stacked on each other and illustrates a cross section of the light-emitting chip 10 taken along line IV-IV in Fig. 3A. The cross section of the island including the stacked VCSEL and setting thyristor S shown in Fig. 4 is seen from the -y direction in Fig. 3A. In Fig. 4, the island 301 including the stacked VCSEL1 and setting thyristor S1 and an island including the stacked VCSEL2 and setting thyristor S2 are shown. On the right side in the drawing, the VCSEL1 and VCSEL2 are not distinguished from each other and are represented as VCSEL collectively, and the setting thyristors S1 and S2 are not distinguished from each other and are represented as setting thyristor S collectively.

As discussed above, the setting thyristor S is stacked on the VCSEL with the tunnel junction layer 84 interposed therebetween. That is, the setting thyristor S and the VCSEL are connected in series with each other.

"On the VCSEL" includes, not only a state in which a certain element directly contacts the VCSEL, but also a state in which a certain element is placed above the VCSEL without directly contacting the VCSEL. The same applies to similar expressions, such as "on the substrate".

As illustrated in Fig. 4, the VCSEL is a semiconductor multilayer body obtained by sequentially growing the n-cathode (DBR) layer 81, light-emitting layer 82, and p-anode (DBR) layer 83 on the n-type substrate 80 by epitaxial growth.

Each of the n-cathode (DBR) layer 81 and the p-anode (DBR) layer 83 is a DBR layer constituted by multiple high refractive index layers having a relatively high refractive index and multiple low refractive index layers having a relatively low refractive index alternately stacked on each other. The n-cathode (DBR) layer 81 and the p-anode (DBR) layer 83 are configured to reflect light emitted from the VCSEL.

The p-anode (DBR) layer 83 includes a current confinement layer 83a. In this example, the current confinement layer 83a is disposed on the side of the p-anode (DBR) layer 83 facing the light-emitting layer 82. The current confinement layer 83a includes a current passing region α and a current blocking region β. As shown in Fig. 4, the current passing region α is positioned at the central portion of the VCSEL, while the current blocking region β is positioned at the peripheral portion of the VCSEL. That is, the portion of the current confinement layer 83a indicated by the thick solid lines serves as the current blocking region β. The portion sandwiched between the two thick solid lines in which the current confinement layer 83a is not provided serves as the current passing region α. The current blocking region β is not required to completely block a current flow, but only needs to concentrate a current in the current passing region α. That is, it is sufficient that the current blocking region β make a current flow less readily than in the current passing region α.

The current confinement layer 83a may be provided in the n-cathode (DBR) layer 81.

Mesa etching performed to separate the island 301 has a depth sufficient to expose the side surfaces of the current confinement layer 83a. When the groove 350 is formed simultaneously with this mesa etching, the groove 350 also has a depth that exposes the side surfaces of the current confinement layer 83a.

The light-emitting layer 82 has a quantum well structure in which well layers and barrier layers are alternately stacked. The light-emitting layer 82 may be an intrinsic (i-type) layer without impurities. The light-emitting layer 82 may alternatively be formed in a structure other than the quantum well structure, such as quantum wires or quantum dots.

The tunnel junction layer 84 is a junction between an n⁺⁺ layer doped with a high-concentration n-type impurity (dopant) and a p⁺⁺ layer doped with a high-concentration p-type impurity. Even when the tunnel junction layer 84 is reverse-biased, a current flows therethrough due to the tunneling effect. The tunnel junction layer 84 suppresses the reduction in current flow through the p-anode (DBR) layer 83 and the setting thyristor S of the VCSEL, which would occur when the p-anode (DBR) layer 83 and the setting thyristor S are reverse-biased. That is, a current flows due to the tunneling effect even when reverse biasing occurs.

The setting thyristor S is constituted by the n-cathode layer 85, p-gate layer 86, n-gate layer 87, and p-anode layer 88 stacked on the tunnel junction layer 84. That is, the setting thyristor S has a four-layer pnpn structure.

The n-cathode layer 85, p-gate layer 86, n-gate layer 87, and p-anode layer 88 are formed by growing p-type semiconductor layers (p-gate layer 86 and p-anode layer 88) made of GaAs, AlGaAs, or AlAs, for example, and n-type semiconductor layers (n-cathode layer 85 and n-gate layer 87) on the substrate 80. The semiconductor layers are grown by MOCVD (Metal Organic Chemical Vapor Deposition) or MBE (Molecular Beam Epitaxy), for example. Hereinafter, the stacked structure of semiconductor layers will be called the semiconductor multilayer body.

The configurations of the substrate 80; the n-cathode (DBR) layer 81, light-emitting layer 82, and p-anode (DBR) layer 83 that form the VCSEL; and the n-cathode layer 85, p-gate layer 86, n-gate layer 87, and p-anode layer 88 that form the setting thyristor S will be described in detail later.

The p-ohmic electrode 321 is made of Au with Zn (AuZn), for example, that readily forms an ohmic contact with a p-type semiconductor layer, such as the p-anode layer 88.

The n-ohmic electrode 331 (see Fig. 3B) is made of Au with Ge (AuGe), for example, that readily forms an ohmic contact with an n-type semiconductor layer, such as the n-gate layer 87.

The back-side electrode 91 is made of AuGe, for example, as in the n-ohmic electrode 331.

In the above-described example, the n-ohmic electrode 331 is disposed on the n-gate layer 87 and is used as the gate Gs of the setting thyristor S. Alternatively, a p-ohmic electrode may be disposed on the p-gate layer 86 and be used as the gate Gs of the setting thyristor S.

In the light-emitting chip 10, a protection layer 90 formed of a transparent insulating material is provided to cover the top and side surfaces of the islands. The protection layer 90 is made of SiO₂, SiON, or SiN, for example.

In the light-emitting chip 10, a light-shielding layer 95 is also provided to reduce a leakage of light output from the setting thyristor S toward the surface of the light-emitting chip 10 through the portions between the islands. Some of the above-described lines may serve as the light-shielding layer 95.

### (Thyristor)

The basic operation of the thyristors (transfer thyristor T and setting thyristor S) will now be explained below. As discussed above, the thyristor is a semiconductor element having a pnpn structure constituted by the n-cathode layer 85, p-gate layer 86, n-gate layer 87, and p-anode layer 88 and having three terminals, that is, an anode terminal (anode), a cathode terminal (cathode), and a gate terminal (gate). In the following explanation, as one example, the forward potential (diffusion potential) Vd of a pn junction constituted by a p-type semiconductor layer and an n-type semiconductor layer is assumed to be 1.5 V.

In the following description, as one example, the substrate potential Vsub to be supplied to the back-side electrode 91 (see Fig. 3B), which is the Vsub terminal, and the reference potential Vst to be supplied to the Vst terminal (reference potential terminal 340) are set to 0 V as a low level potential ("L"), while the power supply potential Vga to be supplied to the Vga terminal is set to 5 V as a high level potential ("H"). The high level potential may be indicated by "H" (5 V), while the low level potential may be indicated by "L" (0 V). "L" (0 V) is a ground potential GND, which is denoted by GND (0 V).

First, the operation of the thyristor alone will be described below. The cathode of the thyristor is assumed to be at 0 V.

The thyristor in the OFF state, in which a current does not flow between the anode and the cathode, transitions to the ON state (turns ON) when a potential higher than a threshold voltage is applied to the anode. The threshold voltage of the thyristor is the sum of the gate potential and the forward potential Vd (1.5 V) of the pn junction. If the gate potential is 1.5 V, the thyristor turns ON when the anode potential exceeds 3 V.

When the thyristor enters the ON state, the gate potential of the thyristor becomes close to the potential of the cathode terminal. Since the cathode is at 0 V, the gate is also taken to be at 0 V. The anode potential of the ON-state thyristor becomes close to the sum of the potential of the cathode and the forward potential Vd (1.5 V) of the pn junction. Since the cathode is at 0 V, the anode potential of the ON-state thyristor becomes close to 1.5 V. The anode potential is determined in relation to the power source for supplying a current to the ON-state thyristor.

The thyristor in the ON state transitions to the OFF state (turns OFF) when the anode potential falls below the potential required to maintain the ON state of the thyristor (close to 1.5 V, which is the above-described forward potential Vd).

Conversely, the thyristor remains in the ON state when a potential higher than the potential required to maintain the ON state is continuously applied to the anode of the thyristor and a current for holding the ON state (holding current) is supplied to the anode.

The operation of the setting thyristor S and the VCSEL stacked on each other will now be described below. Since the substrate potential Vsub is set to "L" (0 V), the cathode of the VCSEL is at 0 V.

As discussed above, the setting thyristor S turns ON when the potential of the light-emission signal φI exceeds the threshold voltage. At this time, since the VCSEL is connected in series with the setting thyristor S, the anode potential of the setting thyristor S becomes close to 3.0 V, which is higher than the cathode potential by an amount equal to the forward voltage potential Vd (1.5 V) of the VCSEL. The difference between this anode potential and the potential of the light-emission signal φI is applied to the current limiting resistor RI (see Fig. 2), and a current equal to a voltage drop generated at the current limiting resistor RI flows through the setting thyristor S and VCSEL in the ON state, thereby turning ON the VCSEL. When the potential of the light-emission signal φI is lower than the threshold, the setting thyristor S does not turn ON and remains in the OFF state.

The ON state of the thyristor can be maintained by supplying a current higher than or equal to the holding current. If a current lower than the holding current is supplied to the thyristor in the ON state, the thyristor switches to the OFF state (turns OFF).

The above-described voltages are only examples and are subject to change in accordance with the emission wavelength and the amount of light of the VCSEL. In this case, the potential ("H") of the light-emission signal φI may be adjusted accordingly.

In the above-described example, the setting thyristor S controls the ON/OFF state of the VCSEL (ON/OFF control). Alternatively, the setting thyristor S may be used as an element for increasing the amount of light emission of the VCSEL in the ON state by turning ON the setting thyristor S.

### (Operation of Light Source Device 1)

The operation of the light source device 1 will now be described below.

The first transfer signal φ1 supplied to the φ1 terminal (see Figs. 2 and 3A) and the second transfer signal φ2 supplied to the φ2 terminal (see Figs. 2 and 3A) each have two potentials, "H" (5 V) and "L" (0 V). The waveform of each of the first and second transfer signals φ1 and φ2 repeats with a cycle consisting of two consecutive periods T (period (T1) and period T(2), for example) that is set as a unit.

A pair of the first and second transfer signals φ1 and φ2 propagates the ON state among the transfer thyristors T in numerical order so as to designate the VCSEL having the same number as the transfer thyristor T in the ON state as the VCSEL to be controlled. As discussed above, when the transfer thyristor T enters the ON state, the gate Gt of the transfer thyristor T goes to 0 V. Then, the gate Gs of the setting thyristor S also goes to 0 V since the gate Gs of the setting thyristor S is connected to the gate Gt of the transfer thyristor T. That is, the threshold voltage of the setting thyristor S becomes 1.5 V. The voltage of the gate Gt of the transfer thyristor T located to the right side of the transfer thyristor T in the ON state rises to 1.8 V by the voltage drop across the coupling diode D and parasitic resistance (not shown) connected in series with the coupling diode D. That is, the threshold voltage of the setting thyristor S whose gate Gs is connected to this gate Gt becomes 3.3 V. The setting thyristor S located further to the right side has an even higher threshold voltage. The gate Gt located to the left side of the transfer thyristor T in the ON state rises to 5 V, and the threshold voltage of the setting thyristor S whose gate Gs is connected to this gate Gt becomes 6.5 V. In this manner, the threshold voltages of all the setting thyristors S other than the setting thyristor S having the same number as the transfer thyristor T in the ON state become 3.3 V or higher.

The light-emission signal φI supplied to the φI terminal (see Figs. 2 and 3A) has two potentials, "H" (5 V) and "L" (0 V).

When the light-emission signal φI shifts from "L" to "H", the setting thyristor S corresponding to the VCSEL selected by the transfer signal turns ON, thereby turning ON the VCSEL. When the setting thyristor S turns ON, the anode voltage rises to 3 V as discussed above, and the voltage of the light-emission signal line 75 also goes to 3 V. Accordingly, the setting thyristors S other than the setting thyristor S corresponding to the selected VCSEL remain OFF.

More specifically, when the transfer thyristor T turns ON, it selects the VCSEL to be controlled, and the light-emission signal φI at "H" (5 V) turns ON the setting thyristor S that is series-connected to the selected VCSEL and thereby turns ON the VCSEL. That is, in the light-emitting chip 10, the ON state of the transfer thyristor T propagates, thereby sequentially turning ON the VCSELs. When the transfer thyristor T turns ON, the potential of the gate Gt is changed and the potential of the gate Gs connected to this gate Gt is also changed, thereby turning ON the setting thyristor S. A signal that is supplied from the gate Gt of the transfer thyristor T to the gate Gs of the setting thyristor S and that turns ON the setting thyristor S will be called the ON signal. Sequentially propagating the ON state makes it easy to control the ON/OFF state of the VCSELs.

The light-emission signal φI at "L" (0 V) maintains the OFF state of the setting thyristor S and also maintains the VCSEL in the OFF state. That is, the light-emission signal φI controls the ON/OFF state of the VCSEL.

The light source device 1 of the first exemplary embodiment includes multiple elements (transfer thyristors T1 through T6, setting thyristors S1 through S6, and VCSEL1 through VCSEL6), and the ON state propagates among these elements to sequentially turn them ON. This will be discussed more specifically. In the light source device 1 in the first exemplary embodiment, under the ON/OFF control of the controller 110 (see Fig. 2), the transfer thyristors T1 through T6 in the transfer section 12 of the light-emitting chip 10 individually enter the ON state. When one of the transfer thyristors T1 through T6 enters the ON state, the corresponding VCSEL to be controlled is selected, and the corresponding one of the setting thyristors S1 through S6 in the light-emitting section 11 turns ON. When this setting thyristor S turns ON, the VCSEL corresponding to this setting thyristor S turns ON. In the light source device 1 of the first exemplary embodiment, the transfer section 12 of the light-emitting chip 10 is an example of a drive unit that individually drives the setting thyristors S so as to bring each of them into the ON state.

In the light-emitting chip 10 of the first exemplary embodiment, the light-emitting region of each VCSEL is the portion of its light-emitting layer 82 that emits light when a current is supplied.

In the light-emitting chip 10 of the first exemplary embodiment, when the setting thyristor S has received the ON signal, current supply to the corresponding VCSEL becomes ready. Then, when the setting thyristor S enters the ON state and a current sufficient for the VCSEL to emit light is supplied, the VCSEL turns ON.

Depending on the configuration of the light-emitting chip 10 or the control scheme of the controller 110, after the ON signal is supplied to the setting thyristor S and current supply to the corresponding VCSEL has become ready, the ON signal supplied to the setting thyristor S may be interrupted while the VCSEL remains capable of emitting light. Even in such a case, when the setting thyristor S turns ON and a current sufficient for the VCSEL to emit light is supplied to the VCSEL, the VCSEL can emit light.

In the first exemplary embodiment, "when the thyristor (setting thyristor S) turns ON, the light-emitting element (VCSEL) can emit light" means that, when the setting thyristor S turns ON, the VCSEL can emit light by supplying a current thereto. In other words, after the ON signal is supplied to the setting thyristor S and the VCSEL enters a state in which it can emit light by current supply, the supply of the ON signal to the setting thyristor S may be continued or be stopped while the VCSEL is emitting light.

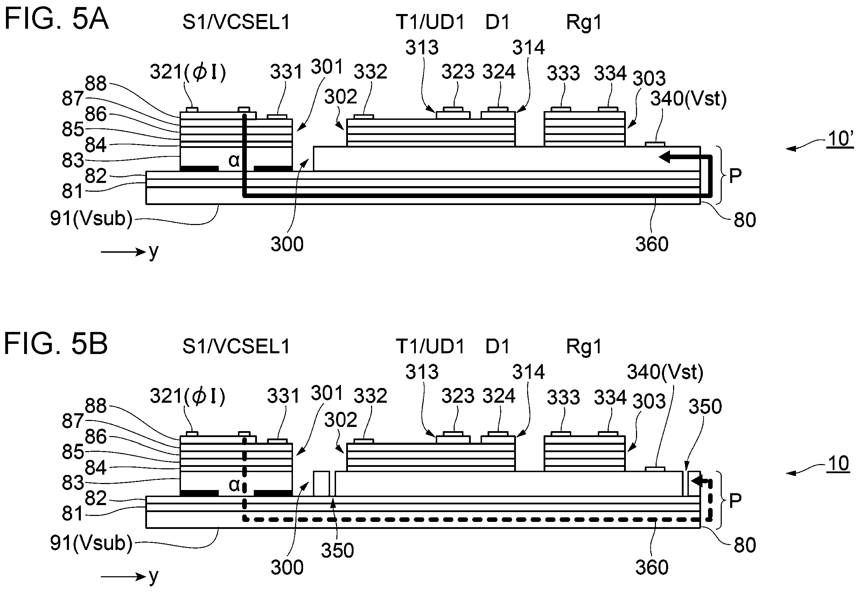

Figs. 5A and 5B are sectional views for explaining a leakage current in the light source device 1 of the first exemplary embodiment. Fig. 5A is a sectional view of a light-emitting chip 10' without a groove 350. Fig. 5B is a sectional view of the light-emitting chip 10 with a groove 350. The horizontal direction in Figs. 5A and 5B corresponds to the +y direction in Fig. 3A. The sectional view of Fig. 5B is the same as that of Fig. 3B.

A description will be given of a case in which the light-emitting chip 10' shown in Fig. 5A is used.

When the setting thyristor S enters the ON state and a current flows through the series-connected setting thyristor S and VCSEL, the current flows from the p-ohmic electrode 321 to the substrate 80 and the back-side electrode 91.

When the semiconductor wafer is diced into individual chips, the side surfaces of the light-emitting chip 10 are susceptible to damage. The side surface P of the light-emitting chip 10 (right edge of the light-emitting chip 10 in Fig. 5A) is an example of a dicing surface. When the n-cathode (DBR) layer 81 and the p-anode (DBR) layer 83 in the island 300 are exposed on the side surface P, which is a dicing surface, the pn junction between the n-cathode (DBR) layer 81 and the p-anode (DBR) layer 83 is subject to damage by dicing. Then, the pn junction is no longer maintained and may be short-circuited. That is, the n-cathode (DBR) layer 81 and the p-anode (DBR) layer 83 may be no longer electrically isolated by the pn junction, and a current may flow in a path via the side surface P damaged by dicing. This will be explained in greater details. A current flowing from the p-ohmic electrode 321 to the setting thyristor S and the VCSEL passes through the inside of the substrate 80 to the side surface P of the light-emitting chip 10 as a leakage current, as shown as a leakage current path 360 indicated by the solid-line arrow in Fig. 5A. Then, the leakage current flows along the side surface P of the light-emitting chip 10 and reaches the p-anode (DBR) layer 83. Then, the leakage current flows to the reference potential terminal 340 from which the reference potential Vst is supplied to the transfer section 12. As a result, the region in the transfer section 12 connected to the reference potential terminal 340 is no longer electrically isolated from the substrate potential Vsub supplied to the substrate 80. The region in the transfer section 12 connected to the reference potential terminal 340 is a region in the p-anode (DBR) layer 83 connected to the reference potential terminal 340, and such a region is located continuously in the island 300.

If a current continues to flow to the reference potential terminal 340, the current may also continue to flow from the p-ohmic electrode 321 to the setting thyristor S and the VCSEL. As a result, the ON state of the setting thyristor S connected to the VCSEL that has emitted light may be maintained, thereby preventing the setting thyristor S from turning OFF and causing a false turn-on.

A description will now be given of a case in which the light-emitting chip 10 shown in Fig. 5B is used.

As illustrated in Fig. 5B, in the light-emitting chip 10 provided with the groove 350 in the first exemplary embodiment, the region in the transfer section 12 connected to the reference potential terminal 340 is electrically isolated from the side surface P of the light-emitting chip 10 by the groove 350.

In the structure in which the n-cathode (DBR) layer 81 and the p-anode (DBR) layer 83 in the island 300 are exposed on the side surface P, a current flowing from the p-ohmic electrode 321 to the setting thyristor S and the VCSEL is likely to pass through the inside of the substrate 80 to the side surface P of the light-emitting chip 10 as a leakage current and to flow from the p-anode (DBR) layer 83 to the reference potential terminal 340, as represented by a leakage current path 360 indicated by the broken-line arrow in Fig. 5B. However, the groove 350 that divides the p-anode (DBR) layer 83 can suppress the flowing of the leakage current to the reference potential terminal 340 through the p-anode (DBR) layer 83. That is, the groove 350 can make it less likely to form the leakage current path 360 between the VCSEL, which is a light-emitting element, and the reference potential terminal 340 via the side surface of the substrate 80. The groove 350 also suppresses extension of the transfer section 12 to the peripheral surface of the substrate 80 of the light-emitting chip 10. The leakage current path 360 is indicated by the broken lines to show that the formation thereof is suppressed. Because of the groove 350, the side surface P, which is a dicing surface, of the light-emitting chip 10 becomes less vulnerable to damage caused by dicing. Additionally, even if dicing-induced damage occurs on the side surface P, it can be accommodated by the provision of the groove 350.

To provide the groove 350, the light-emitting chip 10 may be formed slightly larger by an amount equal to the area of the groove 350. The transfer section 12 is provided on the structure. The p-anode (DBR) layer 83 and the n-cathode (DBR) layer 81 of the structure form a pn junction, and this pn junction isolates the substrate potential Vsub of the substrate 80 (including the back-side electrode 91 and n-cathode (DBR) layer 81) from the reference potential terminal 340 that supplies the reference potential Vst to the transfer section 12. The transfer section 12 does not inherently need to be formed as an island because its function is completed on the structure. However, dicing-induced damage on the side surface of the light-emitting chip 10 degrades the pn-junction isolation. The groove 350 is therefore formed to provide the pn-junction isolation.

The groove 350 is an example of an isolator.

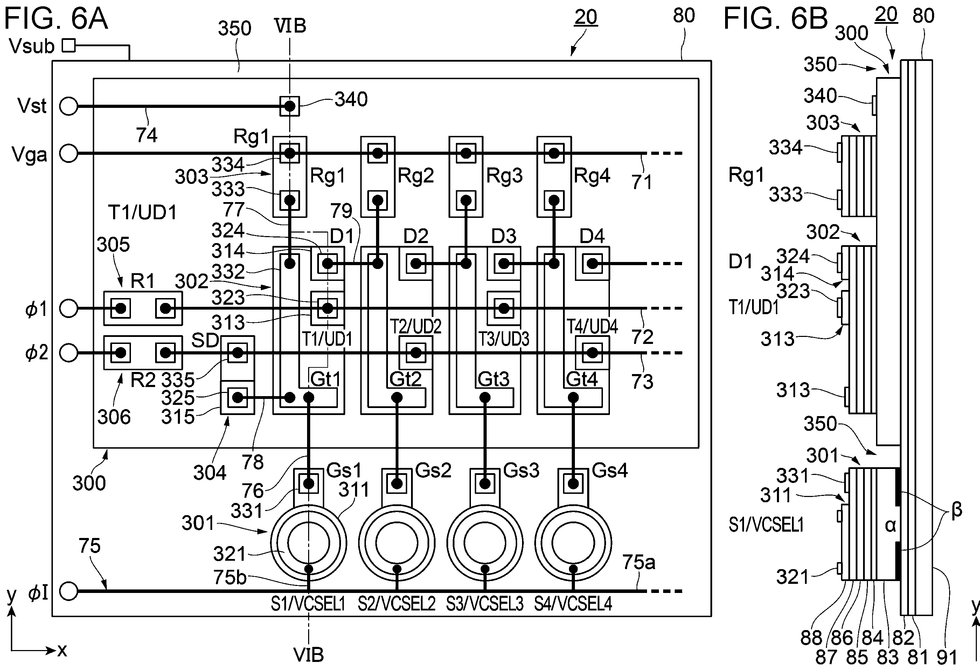

Fig. 6A is a plan view illustrating an example of the layout of a light-emitting chip 20 according to a modified example of the first exemplary embodiment. Fig. 6B is a sectional view taken along line VIB-VIB in Fig. 6A. The light-emitting chip 20 is similar to the light-emitting chip 10 shown in Figs. 3A and 3B, except for the island 300. In the modified example, the island 300 of the light-emitting chip 20, which is different from the island 300 of the first exemplary embodiment, will be discussed.

In the light-emitting chip 10 shown in Fig. 3A, the groove 350 is disposed to surround the transfer section 12 (see Fig. 3A) in the island 300. By providing the groove 350 to surround the transfer section 12, it can be guaranteed that the reference potential Vst and the substrate potential Vsub are isolated from each other. The groove 350 may be disposed in a different manner if it can suppress a leakage current flowing along the side surface of the light-emitting chip 10 to the p-anode (DBR) layer 83 from reaching the reference potential terminal 340 in the transfer section 12 via the p-anode (DBR) layer 83.

In the light-emitting chip 20 shown in Figs. 6A and 6B, the groove 350 is provided along the outer periphery of the light-emitting chip 10. In the light-emitting chip 20, the portion along the outer periphery of the light-emitting chip 20 serves as the groove 350 that is formed by mesa etching down to the p-anode (DBR) layer 83. The portion around the island 301 is also removed by mesa etching to such a degree as to expose the p-anode (DBR) layer 83. Accordingly, the portion around the island 301 can also be regarded as the groove 350.

The electrical isolation between the region in the transfer section 12 connected to the reference potential terminal 340 and the side surface of the light-emitting chip 10 may be implemented by a region in which insulating ions are implanted into the semiconductor layers forming the transfer section 12. The electrical isolation between the region in the transfer section 12 connected to the reference potential terminal 340 and the side surface of the light-emitting chip 10 may be implemented by both of a groove and insulating ions. The region in which insulating ions are implanted becomes insulating and can thus electrically isolate the region in the transfer section 12 connected to the reference potential terminal 340 from the side surface of the substrate 80. The insulating ions are protons (H⁺) for a III-V compound semiconductor, such as GaAs, AlGaAs, or AlAs.

When insulating ions are used to electrically isolate the region in the transfer section 12 connected to the reference potential terminal 340 from the side surface P of the light-emitting chip 10, they may be implanted to surround the transfer section 12, similarly to when the groove 350 of the light-emitting chip 10 shown in Fig. 3A is formed, or to extend along the outer periphery of the light-emitting chip 20, similarly to when the groove 350 is formed along the outer periphery of the light-emitting chip 20 shown in Fig. 6A. The isolating ions are implanted at least to a depth to divide the p-anode (DBR) layer 83 or may be implanted even deeper.

The region in which insulating ions are implanted is another example of the isolator. The isolator may be constituted partly by a groove and partly by insulating ions. The isolator may not necessarily be formed to surround the transfer section 12 of the light-emitting chip 10 or to extend along the entire periphery of the light-emitting chip 20. Instead, the isolator may be provided only in portions where the leakage current path 360 is likely to be formed, so as to prevent the formation of the leakage current path 360 in those portions.

In the above-described configuration of the first exemplary embodiment, the isolator, such as the groove 350, can suppress extension of the p-anode (DBR) layer 83 placed under the transfer section 12 and connected to the reference potential terminal 340 to the outer periphery of the light-emitting chip 10.

### [Second Exemplary Embodiment]

In the first exemplary embodiment, the cathode-common light-emitting chip 10 has been described. In a second exemplary embodiment, an anode-common light-emitting chip 30 will be discussed below. The measurement apparatus 100 in the second exemplary embodiment is similar to that in the first exemplary embodiment.

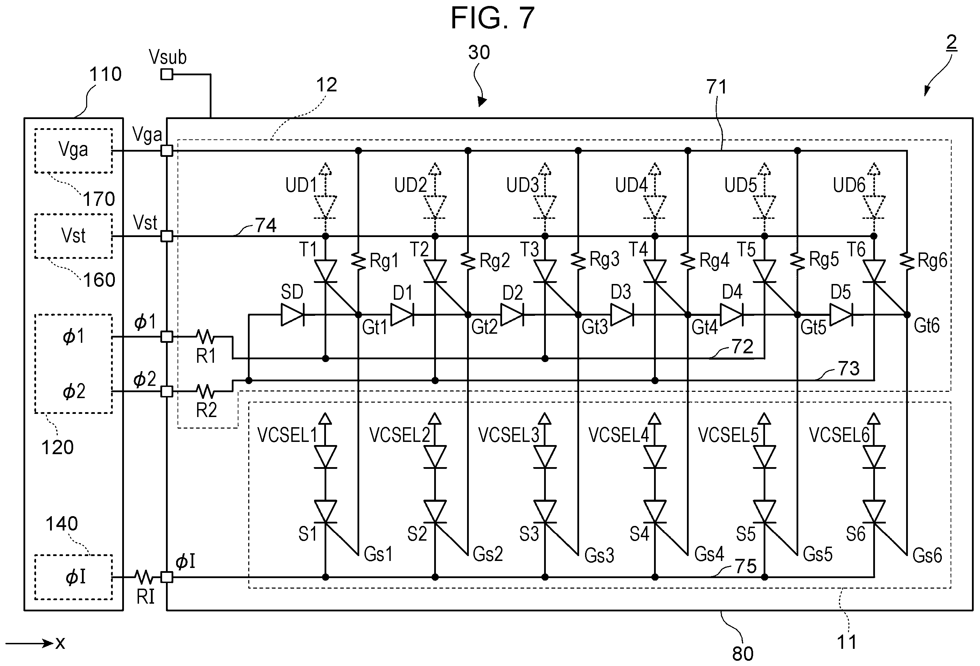

Fig. 7 is an equivalent circuit diagram of a light source device 2 according to the second exemplary embodiment. In Fig. 7, the rightward direction in the drawing is taken as the +x direction. Elements having similar functions to those of the light source device 1 of the first exemplary embodiment are designated by like reference numerals and a detailed description thereof will be omitted.

The light source device 2 shown in Fig. 7 includes a light-emitting chip 30 and a controller 110.

### (Controller 110)

The controller 110 includes a transfer signal generator 120, a light-emission signal generator 140, a reference potential supplier 160, and a power supply potential supplier 170.

The transfer signal generator 120 generates a first transfer signal φ1 and a second transfer signal φ2 for sequentially propagating the ON state among multiple transfer thyristors T in the transfer section 12. The light-emission signal generator 140 generates a light-emission signal φI for supplying a current that causes multiple VCSELs to turn ON (emit light). The reference potential supplier 160 supplies a reference potential Vst for the transfer section 12. The power supply potential supplier 170 supplies a power supply potential Vga. The functions of these elements are similar to those of the light source device 1. However, the first and second transfer signals φ1 and φ2, light-emission signal φI, reference potential Vst, and power supply potential Vga have the same absolute values as those of the light source device 1 but with opposite polarities. That is, these signals have negative potentials with respect to the ground potential GND (0 V).

### (Light-Emitting Chip 30)

The light-emitting chip 30 includes a light-emitting section 11 and a transfer section 12. The light-emitting chip 30 includes a φ1 terminal, a φ2 terminal, a Vga terminal, a φI terminal, and a Vst terminal. The light-emitting chip 30 also includes a Vsub terminal. The Vsub terminal is a back-side electrode 91 provided on the back side of the substrate 80. In Fig. 7, the terminals of elements connected to the substrate 80 (that is, the Vsub terminal) are represented by triangle symbols.

The light-emitting section 11 includes VCSELs (Vertical Cavity Surface Emitting Lasers). In the example in Fig. 7, six VCSEL1 through VCSEL6 are provided. The light-emitting section 11 also includes six setting thyristors S1 through S6. The cathode of the VCSEL and the anode of the setting thyristor S are connected to each other.

The transfer section 12 includes six transfer thyristors T1 through T6 and six underlying diodes UD1 through UD6. Among the transfer thyristors T1 through T6 and the underlying diodes UD1 through UD6, the transfer thyristor T and the underlying diode UD having the same number are connected in series with each other. Like the light-emitting chip 10 shown in Fig. 3B, the transfer thyristor T is stacked on the corresponding underlying diode UD formed on the substrate 80. The underlying diodes UD1 through UD6 are not separated from each other but are integrally formed. The underlying diodes UD1 through UD6 do not function as active diodes. In Fig. 7, the underlying diodes UD1 through UD6 are indicated by the broken lines.

In the transfer section 12, the transfer thyristors T1 through T6 are grouped into pairs in numerical order and coupling diodes D1 through D5 are disposed between adjacent transfer thyristors T of the respective pairs.

The transfer section 12 also includes power supply line resistors Rg1 through Rg6.

The transfer section 12 also includes a start diode SD.

The transfer section 12 also includes current limiting resistors R1 and R2. The current limiting resistor R1 prevents an excessive current from flowing through the first transfer signal line 72 through which the first transfer signal φ1 is transmitted, while the current limiting resistor R2 prevents an excessive current from flowing through the second transfer signal line 73 through which the second transfer signal φ2 is transmitted. The first and second transfer signal lines 72 and 73 will be discussed later.

The VCSEL1 through VCSEL6 and the setting thyristors S1 through S6 of the light-emitting section 11 and the transfer thyristors T1 through T6, underlying diodes UD1 through UD6, coupling diodes D1 through D5, and power supply line resistors Rg1 through Rg6 of the transfer section 12 are arranged in numerical order from one side (-x-direction side and the left side in Fig. 7) to the other side (+x-direction side and the right side in Fig. 7).

In the second exemplary embodiment, as in the first exemplary embodiment, the numbers of VCSELs and setting thyristors S of the light-emitting section 11 and the numbers of transfer thyristors T, underlying diodes UD, and power supply line resistors Rg of the transfer section 12 are all six. The number of coupling diodes D is five, which is one less than the number of transfer thyristors T. The above-described numbers of VCSELs, setting thyristors S, transfer thyristors T, underlying diodes UD, power supply line resistors Rg, and coupling diodes D are only examples, and predetermined numbers of the above-described elements may be set. The number of transfer thyristors T may be greater than that of VCSELs.

Electrical connection of the elements of the light-emitting chip 30 will now be described below.

The anodes of the VCSELs and the underlying diodes UD are connected to the substrate 80 (anode common). The substrate potential Vsub is supplied to these anodes via the back-side electrode 91 (see Fig. 3B), which is the Vsub terminal, disposed on the back side of the substrate 80.

The cathode of each VCSEL is connected to the anode of the corresponding setting thyristor S. The cathode of each underlying diode UD is connected to the anode of the corresponding transfer thyristor T. The anode of the transfer thyristor T (sharing the same node as the cathode of the underlying diode UD) is connected to the reference potential line 74. The reference potential line 74 is connected to the Vst terminal. The reference potential Vst is supplied from the reference potential supplier 160 to the Vst terminal. The Vst terminal may be the reference potential terminal 340 shown in Figs. 3A and 3B.

In accordance with the arrangement of the transfer thyristors T, the anodes of the odd-numbered transfer thyristors T1, T3, and T5 are connected to the first transfer signal line 72. The first transfer signal line 72 is connected to the φ1 terminal via the current limiting resistor R1. The first transfer signal φ1 is supplied from the transfer signal generator 120 of the controller 110 to the φ1 terminal.

In accordance with the arrangement of the transfer thyristors T, the anodes of the even-numbered transfer thyristors T2, T4, and T6 are connected to the second transfer signal line 73. The second transfer signal line 73 is connected to the φ2 terminal via the current limiting resistor R2. The second transfer signal φ2 is supplied from the transfer signal generator 120 of the controller 110 to the φ2 terminal.

The cathodes of the setting thyristors S are connected to the light-emission signal line 75. The light-emission signal line 75 is connected to the φI terminal. The light-emission signal φI is supplied from the light-emission signal generator 140 of the controller 110 to the φI terminal via the current limiting resistor RI disposed outside the light-emitting chip 30. The light-emission signal φI serves to supply a light-emission current to a selected VCSEL.

Gates Gt1 through Gt6 of the transfer thyristors T1 through T6 are respectively connected to gates Gs1 through Gs6 of the setting thyristors S1 through S6 based on a one-to-one correspondence. Accordingly, among the gates Gt1 through Gt6 and the gates Gs1 through Gs6, the gate Gt and the gate Gs having the same number are electrically at the same potential.

The gates Gt1 through Gt6 of the transfer thyristors T1 through T6 are grouped into pairs in numerical order, and the coupling diodes D1 through D5 are connected between adjacent gates Gt of the respective pairs. That is, the coupling diodes D1 through D5 are directly connected so as to be sandwiched between adjacent gates Gt of the respective pairs. The coupling diode D1 is connected in the direction in which a current flows from the gate Gt1 to the gate Gt2. The other coupling diodes D2 through D5 are connected in a similar manner.

The gates Gt (gates Gs) of the transfer thyristors T are connected to a power supply line 71 via the power supply line resistors Rg provided for the respective transfer thyristors T. The power supply line 71 is connected to the Vga terminal. The power supply potential Vga is supplied from the power supply potential supplier 170 of the controller 110 to the Vga terminal.

The gate Gt1 of the transfer thyristor T is connected to the cathode of the start diode SD. The anode of the start diode SD is connected to the second transfer signal line 73.

The layout of the light-emitting chip 30 in a plan view is similar to that of the first exemplary embodiment shown in Fig. 3A, and a cross section of the light-emitting chip 30 is similar to that shown in Fig. 3B. The light-emitting chip 10 shown in Fig. 3B uses a semiconductor multilayer body in which the n-cathode (DBR) layer 81, light-emitting layer 82, p-anode (DBR) layer 83, tunnel junction layer 84, n-cathode layer 85, p-gate layer 86, n-gate layer 87, and p-anode layer 88 are sequentially disposed on the n-type substrate 80 in this order. The light-emitting chip 30 uses a semiconductor multilayer body in which a p-anode (DBR) layer, a light-emitting layer, an n-cathode (DBR) layer, a tunnel junction layer, a p-anode layer, an n-gate layer, a p-gate layer, and an n-cathode layer are sequentially disposed on a p-type substrate in this order. That is, the polarity of the n-type and p-type layers and that of the n-type and p-type substrate are reversed.

As described above, by supplying signals with the negative polarity from the controller 110, the light-emitting chip 30 can be operated similarly to the light-emitting chip 10. The groove 350 may also be arranged similarly to that in the light-emitting chip 10.

### [Third Exemplary Embodiment]

In the light-emitting chips 10 and 20 of the first exemplary embodiment and the light-emitting chip 30 of the second exemplary embodiment, two adjacent transfer thyristors T in the transfer section 12 are coupled by the corresponding coupling diode D. In a light-emitting chip 40 of a third exemplary embodiment, two adjacent transfer thyristors T in the transfer section 12 are coupled by a coupling transistor Q. The measurement apparatus 100 in the third exemplary embodiment is similar to that in the first exemplary embodiment.

### (Light Source Device 3)

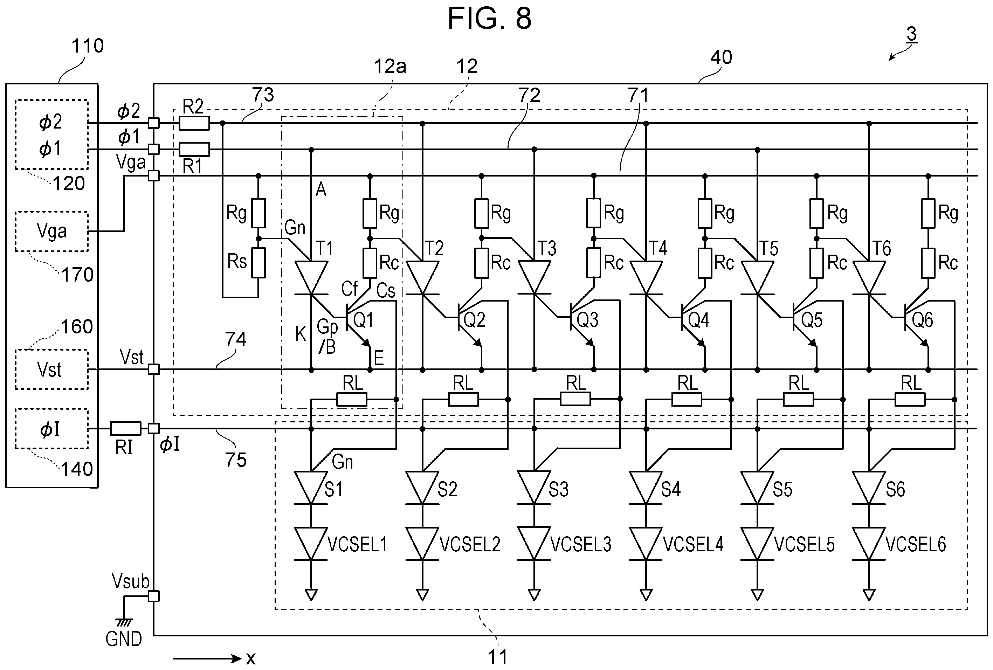

Fig. 8 is an equivalent circuit diagram of a light source device 3 according to the third exemplary embodiment. In Fig. 8, the rightward direction in the drawing is taken as the +x direction.

The light source device 3 shown in Fig. 8 includes a light-emitting chip 40 and a controller 110. The light-emitting chip 40 is a cathode-common light-emitting chip, as in the light-emitting chip 10 of the first exemplary embodiment. The controller 110 is configured similarly to that of the light source device 1 of the first exemplary embodiment.

### (Light-Emitting Chip 40)

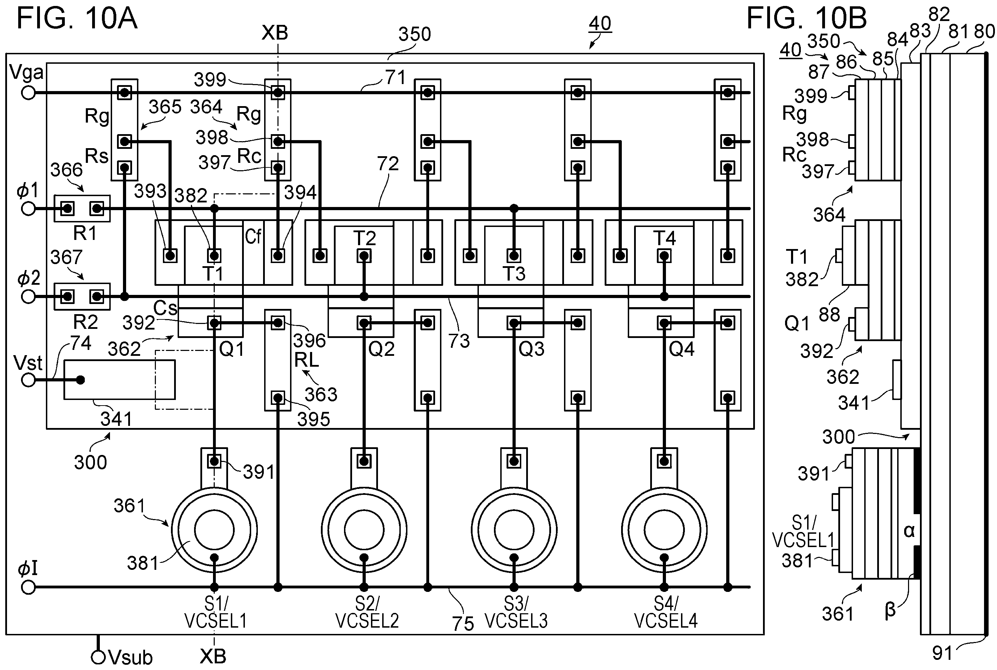

The light-emitting chip 40 includes a light-emitting section 11 and a transfer section 12. The functions of the light-emitting section 11 and the transfer section 12 of the light-emitting chip 40 are similar to those of the light-emitting chip 10. As in the light-emitting chip 10, the light-emitting chip 40 includes a φ1 terminal, a φ2 terminal, a Vga terminal, a φI terminal, and a Vst terminal. The light-emitting chip 40 also includes a Vsub terminal. As in the light-emitting chip 10, the Vsub terminal is a back-side electrode 91 (see Fig. 10B, which will be discussed later) provided on the back side of the substrate 80. In Fig. 8, the terminals of elements connected to the substrate 80 (that is, the Vsub terminal) are represented by inverted triangle symbols. These terminals are configured similarly to those of the light-emitting chip 10. The terminals other than the Vsub terminal are connected to the controller 110, as in the corresponding terminals in the light source device 1 of the first exemplary embodiment. In Fig. 8, the resistors are represented by rectangles.

As in the light-emitting chip 10 of the first exemplary embodiment, the light-emitting section 11 of the light-emitting chip 40 includes multiple pairs of series-connected VCSELs and setting thyristors S. In the example in Fig. 8, six VCSELs (VCSEL1 through VCSEL6) and six setting thyristors S (S1 through S6) are shown. The anode of the VCSEL and the cathode of the setting thyristor S having the same number are connected to each other. The six VCSELs and the six setting thyristors S are arranged from one side (-x-direction side) to the other side (+x-direction side).

The transfer section 12 includes transfer thyristors T, coupling transistors Q, power supply line resistors Rg, current limiting resistors RL, and coupling resistors RC. In Fig. 8, six transfer thyristors T (T1 through T6) and six coupling transistors Q (Q1 through Q6) are shown. The transfer section 12 includes six power supply line resistors Rg, six current limiting resistors RL, and six coupling resistors RC, but individual reference numerals are omitted. One transfer thyristor T, one coupling transistor Q, one power supply line resistor Rg, one current limiting resistor RL, and one coupling resistor RC form a transfer unit 12a. Six transfer units 12a are arranged from one side (-x-direction side) to the other side (+x-direction side). The transfer section 12 includes a power supply line resistor Rg and a start resistor Rs at the end of the -x-direction side. The transfer section 12 also includes current limiting resistors R1 and R2.

In the transfer unit 12a, the setting thyristor S and the coupling transistor Q are connected to each other. The coupling transistor Q in the transfer unit 12a is connected to the setting thyristor S of the light-emitting section 11. The setting thyristors S1 through S6 are connected to the coupling transistors Q1 through Q6, respectively. The coupling transistors Q1 through Q6 are connected to the setting thyristors S1 through S6, respectively. In Fig. 8, the six transfer thyristors T, six coupling transistors Q, six setting thyristors S, and six VCSELs are shown, but the numbers of these elements are not limited to six.

Like the light-emitting chip 10 of the first exemplary embodiment shown in Fig. 2, underlying diodes UD, which are configured similarly to VCSELs, are disposed in the transfer section 12, though they are not shown in Fig. 8. The underlying diodes UD do not function as active diodes, as in those in the light-emitting chip 10.

In the light-emitting chip 40, the Vga terminal is connected to the power supply line 71, the Vst terminal is connected to the reference potential line 74, the φ1 terminal is connected to the first transfer signal line 72, the φ2 terminal is connected to the second transfer signal line 73, and the φI terminal is connected to the light-emission signal line 75. The Vsub terminal is grounded at the ground potential GND (0 V).

### (Operations of Transfer Thyristor T, Coupling Transistor Q, VCSEL, and Setting Thyristor S)

The basic operation of the light-emitting chip 40 will be described below.

Each of the transfer thyristor T and the setting thyristor S is an npnp thyristor. The thyristor includes an n-type cathode K (hereinafter simply called the cathode K; the same applies hereinafter), a p-type gate Gp (p-gate Gp), an n-type gate Gn (n-gate Gn), and a p-type anode A (anode A). The setting thyristor S does not use the p-gate Gp for its control operation. Accordingly, the p-gate Gp is not shown for the setting thyristor S. In the light-emitting chip 10 of the first exemplary embodiment, the gate of the transfer thyristor T is set to the gate Gt, and the gate of the setting thyristor S is set to the gate Gs. In the light-emitting chip 40, since the p-type gate Gp (p-gate Gp) is also used, the gates are designated as the p-type gate Gp (p-gate Gp) and the n-type gate Gn (n-gate Gn) so as to be distinguished from each other. The gate Gt of the transfer thyristor T and the gate Gs of the setting thyristor S in the light-emitting chip 10 correspond to the n-gate Gn.

The coupling transistor Q is a multi-collector npn bipolar transistor. The coupling transistor Q has an n-type emitter E (emitter E), a p-type base B (base B), and n-type collectors Cf and Cs (collectors Cf and Cs).

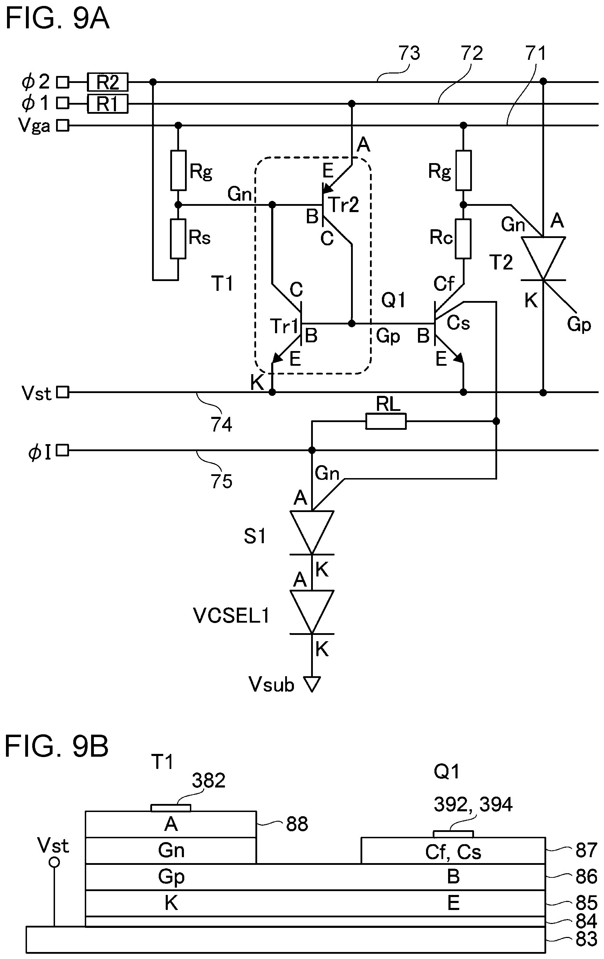

The above-described reference signs for the thyristor are used for all the thyristors, and the above-described reference signs for the coupling transistor are used for all the coupling transistors. Bipolar transistors forming a thyristor discussed below are also represented by these reference signs. The thyristor is constituted by a combination of a single-collector npn bipolar transistor and a single-collector pnp bipolar transistor (see Fig. 9A, which will be discussed later), and is thus also represented by an emitter E, a base B, and a collector C. Hereinafter, the anode, cathode, n-gate, p-gate, emitter, base, and collector will be denoted by the anode A, cathode K, n-gate Gn, p-gate Gp, emitter E, base B, and collector C, respectively, even when these reference signs are not shown in the drawings.

The transfer thyristor T, coupling transistor Q, setting thyristor S, and VCSEL are formed by a III-V compound semiconductor, such as GaAs. As discussed above, the forward voltage (diffusion potential) Vd of a junction formed in this compound semiconductor is set to 1.5 V, while the saturation voltage Vc of a bipolar transistor formed by the compound semiconductor is set to 0.3 V. The power supply potential Vga is set to 5 V ("H" (5 V)). For the first and second transfer signals φ1 and φ2 and the light-emission signal φI, the L level is assumed to be 0 V ("L" (0 V)) and the H level is assumed to be 5 V ("H" (5 V)). The ground potential GND is GND (0 V).

Fig. 9A is an equivalent circuit diagram illustrating the operation of the light-emitting chip 40 according to the third exemplary embodiment. Fig. 9B is a partial sectional view illustrating the transfer thyristor T1 and the coupling transistor Q1 shown in Fig. 9A. In Fig. 9A, the transfer thyristor T2 is also shown.

As shown in Fig. 9A, the transfer thyristor T1 is constituted by a combination of an npn bipolar transistor Tr1 (hereinafter called the npn transistor Tr1) and a pnp bipolar transistor Tr2 (hereinafter called the pnp transistor Tr2). The base B of the npn transistor Tr1 is connected to the collector C of the pnp transistor Tr2. The collector C of the npn transistor Tr1 is connected to the base B of the pnp transistor Tr2. The emitter E of the npn transistor Tr1 serves as the cathode K of the transfer thyristor T1. The collector C of the npn transistor Tr1 (base B of the pnp transistor Tr2) serves as the n-gate Gn of the transfer thyristor T1. The collector C of the pnp transistor Tr2 (base B of the npn transistor Tr1) serves as the p-gate Gp of the transfer thyristor T1. The emitter E of the pnp transistor Tr2 serves as the anode A of the transfer thyristor T1.

The emitter E of the npn transistor Tr1, which serves as the cathode K of the transfer thyristor T1, is connected to the reference potential line 74 connected to the Vst terminal to which the reference potential Vst is supplied. The emitter E of the pnp transistor Tr2, which serves as the anode A of the transfer thyristor T1, is connected to the first transfer signal line 72. The n-gate Gn is connected to a node between the start resistor Rs and the power supply line resistor Rg connected in series with each other. The end of the start resistor Rs, which is not connected to the power supply line resistor Rg, is connected to the second transfer signal line 73. The end of the power supply line resistor Rg, which is not connected to the start resistor Rs, is connected to the power supply line 71. The first transfer signal line 72 is connected to the φ1 terminal and receives the first transfer signal φ1. The second transfer signal line 73 is connected to the φ2 terminal and receives the second transfer signal φ2. The power supply line 71 is connected to the Vga terminal and receives the power supply potential Vga.

Regarding the coupling transistor Q1, which is an npn transistor, the base B is connected to the p-gate Gp of the transfer thyristor T1 (the base B of the npn transistor Tr1 and the collector C of the pnp transistor Tr2), and the emitter E is connected to the reference potential line 74. The collector Cf of the coupling transistor Q1 is connected to the power supply line 71 via the series-connected coupling resistor Rc and power supply line resistor Rg. The node between the coupling resistor Rc and the power supply line resistor Rg is connected to the n-gate Gn of the transfer thyristor T2.

The npn transistor Tr1 of the transfer thyristor T1 and the coupling transistor Q1 form a current mirror circuit. A current proportional to a current flowing through the npn transistor Tr1 flows through the coupling transistor Q1.

The collector Cs of the coupling transistor Q1 is connected to the n-gate Gn of the setting thyristor S1 and is also connected to the light-emission signal line 75 via the current limiting resistor RL. The light-emission signal line 75 is connected to the φI terminal and receives the light-emission signal φI.

As stated above, the VCSEL1 and the setting thyristor S1 are series-connected. The anode A of the VCSEL1 and the cathode K of the setting thyristor S1 are connected to each other. The anode A of the setting thyristor S1 is connected to the light-emission signal line 75. The cathode K of the VCSEL1 is connected to the substrate 80 having the substrate potential Vsub.

The anode A of the transfer thyristor T2 is connected to the second transfer signal line 73. As shown in Fig. 8, the anodes A of the odd-numbered transfer thyristors T are connected to the first transfer signal line 72, while the anodes A of the even-numbered transfer thyristors T are connected to the second transfer signal line 73. Except for the difference in the connection relationship of the transfer thyristors T to the first and second transfer signal lines 72 and 73, the connection relationships of the transfer thyristors T of number 2 and higher, corresponding coupling transistors, setting thyristors S, and VCSELs are similar to those of the transfer thyristor T1, coupling transistor Q1, setting thyristor S1, and VCSEL1.

### (Operation of Transfer Thyristor S)

First, the operation of the transfer thyristors T1 and T2 will be described below.

The power supply potential Vga (power supply line 71) is set to 5 V, and the reference potential Vst (reference potential line 74) is set to the ground potential GND (0 V). The first and second transfer signals φ1 and φ2 and the light-emission signal φI are set to "L" (0 V). At this time, the npn transistor Tr1 and the pnp transistor Tr2 forming the transfer thyristor T1 are in the OFF state. The n-gate Gn of the transfer thyristor T1 is connected to the node between the series-connected start resistor Rs and power supply line resistor Rg. The end of the start resistor Rs, which is not connected to the power supply line resistor Rg, is connected to the second transfer signal line 73 set at "L" (0 V). The end of the power supply line resistor Rg, which is not connected to the start resistor Rs, is connected to the power supply line 71 set at 5 V. Accordingly, the voltage at the n-gate Gn becomes the divided voltage of the voltage difference (5 V) across the start resistor Rs and the power supply line resistor Rg. If the resistance ratio between the start resistor Rs and the power supply line resistor Rg is 1:5, for example, the voltage at the n-gate Gn becomes 0.83 V. This state will be referred to as the initial state.

At the initial state, the first transfer signal φ1 (first transfer signal line 72) is changed from "L" (0 V) to "H" (5 V). Then, the emitter E of the pnp transistor Tr2 of the transfer thyristor T1 rises to "H" (5 V). The voltage difference (4.17 V) between the emitter E ("H" (5 V)) and the base B (p-gate Gp) (0.83 V) exceeds the forward voltage Vd (1.5 V), and the junction between the emitter E and the base B is forward-biased. The pnp transistor Tr2 thus transitions from the OFF state to the ON state. Then, the voltage at the collector C of the pnp transistor Tr2 (the base B of the npn transistor Tr1) rises to 4.7 V, which is the difference between the voltage at the emitter E ("H" (5 V)) and the saturation voltage Vc (0.3 V). The voltage difference (4.7 V) between the emitter E (0 V) and the base B (4.7 V) of the npn transistor Tr1 exceeds the forward voltage Vd (1.5 V). The junction between the emitter E and the base B is thus forward-biased, and the npn transistor Tr1 transitions from the OFF state to the ON state. Since both of the npn transistor Tr1 and the pnp transistor Tr2 of the transfer thyristor T1 turn ON, the transfer thyristor T1 transitions from the OFF state to the ON state (turns ON).

When the first transfer signal φ1 shifts from "L" (0 V) to "H" (5 V) in the initial state, the transfer thyristor T1 turns ON and transitions from the OFF state to the ON state.

When the transfer thyristor T1 turns ON, the voltage at the n-gate Gn of the transfer thyristor T1 drops to 0.3 V, which is the saturation voltage Vc. The voltage at the anode A is determined by the total voltage (Vd+Vc) of the forward voltage Vd and the saturation voltage Vc and by a voltage drop due to the internal resistance of the transfer thyristor T. In this example, the voltage at the anode A becomes 1.9 V. That is, when the transfer thyristor T1 turns ON, the voltage of the first signal line 72 shifts from 5 V to 1.9 V. Then, the voltage at the p-gate Gp of the transfer thyristor T1 then becomes 1.6 V.

As described above, the transfer thyristor T1 turns ON when the voltage at the n-gate Gn becomes lower than the voltage at the anode A by an amount greater than or equal to the forward voltage Vd (1.5 V). The transfer thyristor T1 turns OFF when the voltage of the first transfer signal line 72 (the voltage difference between the anode A and the cathode K) becomes lower than 1.9 V. For example, when the anode A drops to "L" (0 V), the voltage difference between the anode A and the cathode K becomes 0 V, and the transfer thyristor T1 turns OFF. On the other hand, when the voltage of the first transfer signal line 72 (voltage difference between the anode A and the cathode K) is 1.9 V or higher, the ON state of the transfer thyristor T1 is maintained. Hence, 1.9 V will be referred to as the holding voltage. Even when the holding voltage is applied, if no current flows to maintain the ON state of the transfer thyristor T1, the ON state of the transfer thyristor T1 is not maintained. The current for holding the ON state will be referred to as the holding current.

Next, the operation of the coupling transistor Q1 will be described below.

When the transfer thyristor T1 is in the OFF state, the npn transistor Tr1 is also in the OFF state. Accordingly, the coupling transistor Q1 also remains OFF. The emitter E of the coupling transistor Q1 is connected to the reference potential line 74. Since the reference potential Vst is set to the ground potential GND (0 V), the reference potential line 74 is at the ground potential GND (0 V). Accordingly, the emitter E is also at the ground potential GND (0 V). The collector Cf is at the power supply potential Vga (5 V) via the series-connected power supply line resistor Rg and coupling resistor Rc. The collector Cs is at 0 V, which is the potential (0 V) of the light-emission signal φI ("L" (0 V)), via the current limiting resistor RL.

When the transfer thyristor T1 turns ON, that is, when the npn transistor Tr1 enters the ON state, the voltage of the p-gate Gp of the transfer thyristor T1 becomes 1.6 V, as discussed above. Since the base B of the coupling transistor Q1 is connected to the p-gate Gp of the transfer thyristor T1, the voltage at the junction between the emitter E and the base B rises to the forward voltage Vd (1.5 V) or higher. That is, the junction between the emitter E and the base B is forward-biased, and the coupling transistor Q1 transitions from the OFF state to the ON state. Then, the voltage at the collector Cf becomes equal to the saturation voltage Vc (0.3 V). The voltage at the collector Cs will be discussed later. The node between the power supply line resistor Rg and the coupling resistor Rc (n-gate Gn of the transfer thyristor T2) is at the voltage obtained by dividing the voltage difference (4.7 V) between the power supply voltage (5 V) of the power supply line 71 and the voltage (0.3 V) of the collector Cf by the power supply line resistor Rg and the coupling resistor Rc. If the voltage ratio between the power supply line resistor Rg and the coupling resistor Rc is 5:1, for example, the voltage at the node between the power supply line resistor Rg and the coupling resistor Rc (n-gate Gn of the transfer thyristor T2) becomes 1.08 V.

The anode A of the transfer thyristor T2 is connected to the second transfer signal line 73 to which the second transfer signal φ2 is supplied. Since the second transfer signal φ2 is at "L" (0 V), the transfer thyristor T2 does not turn ON. When the second transfer signal φ2 transitions from "L" (0 V) to "H" (5 V), the voltage at the anode A of the transfer thyristor T2 shifts to "H" (5 V). The voltage difference (3.92 V) between the anode A and the n-gate Gn (1.08 V) becomes higher than the forward voltage Vd (1.5 V). That is, the junction between the n-gate Gn and the anode A is forward-biased, and the transfer thyristor T2 turns ON. In this manner, the ON state sequentially propagates among the transfer thyristors T by the first and second transfer signals φ1 and φ2.

The operation of the setting thyristor S1 and the VCSEL1 will now be described below.

When the coupling transistor Q1 turns ON, the voltage at the collector Cs becomes equal to the saturation voltage Vc (0.3 V), as does the voltage at the collector Cf. The n-gate Gn of the setting thyristor S1 is connected to the collector Cs of the coupling transistor Q1 and thus becomes 0.3 V.

The light-emission signal φI transitions from "L" (0 V) to "H" (5 V). Since the anode A of the setting thyristor S1 is connected to the light-emission signal line 75 to which the light-emission signal φI is supplied, the anode A of the setting thyristor S1 rises to "H" (5 V). The cathode K of the VCSEL1 is connected to the substrate 80 (Vsub terminal), which is set at the ground potential GND (0 V). Accordingly, when the light-emission signal φI transitions from "L" (0 V) to "H" (5 V), "H" (5 V) is applied across the series-connected setting thyristor S1 and VCSEL1, and also, the voltage difference between the anode A and the n-gate Gn of the setting thyristor S becomes 4.7 V, thereby forward-biasing the junction between the anode A and the gate Gn. As a result, the setting thyristor S1 turns ON, thereby allowing a current to flow through the VCSEL1 and turning it ON.

In the initial state, the power supply line 71 is at the power supply potential Vga (5 V), the reference potential Vst of the reference potential line 74 and the substrate potential Vsub are set at the ground potential GND (0 V), and the first and second transfer signals φ1 and φ2 are at "L" (0 V). In the initial state, the transfer thyristor T1 enters a state in which it can transition to the ON state. In this state, when the first transfer signal φ1 (first transfer signal line 72) shifts from "L" (0 V) to "H" (5 V), the transfer thyristor T1 turns ON and transitions from the OFF state to the ON state. Then, the coupling transistor Q1 transitions from the OFF state to the ON state. When the light-emission signal φI (light-emission signal line 75) shifts from "L" (0 V) to "H" (5 V), the junction between the anode A and the n-gate Gn of the setting thyristor S1 is forward-biased, thereby turning ON the VCSEL1. When the coupling transistor Q1 turns ON, the transfer thyristor T2 enters a state in which it can transition to the ON state. When the second transfer signal φ2 (second transfer signal line 73) shifts from "L" (0 V) to "H" (5 V), the transfer thyristor T2 turns ON. When the first transfer signal φ1 (first transfer signal line 72) shifts from "H" (5 V) to "L" (0 V), the voltage across the cathode K and the anode A of the transfer thyristor T1 drops to 0 V, thereby turning OFF the transfer thyristor T1. The other transfer thyristors T, coupling transistors Q, and setting thyristors S, and VCSELs operate in a similar manner.

As illustrated in Fig. 9B, the light-emitting chip 40 is constituted by a semiconductor multilayer body including multiple semiconductor layers stacked on each other (see also Fig. 10B, which will be discussed later). The semiconductor multilayer body is similar to that of the light-emitting chip 10. Fig. 9B illustrates part of the light-emitting chip 40, that is, stacked layers of a p-anode (DBR) layer 83, a tunnel junction layer 84, an n-cathode layer 85, a p-gate layer 86, an n-gate layer 87, and a p-anode layer 88 which form the transfer thyristor T1 and the coupling transistor Q1. The transfer thyristor T1 uses the n-cathode layer 85 as the cathode K, the p-gate layer 86 as the p-gate Gp, the n-gate layer 87 as the n-gate Gn, and the p-anode layer 88 as the anode A. The coupling transistor Q1 uses the n-cathode layer 85 as the emitter E, the p-gate layer 86 as the base B, and the n-gate layer 87 as the collectors Cf and Cs. The p-anode (DBR) layer 83 is connected to the Vst terminal (reference potential terminal 341) that supplies the reference potential Vst for the transfer section 12. The p-anode (DBR) layer 83, tunnel junction layer 84, and n-cathode layer 85 are at the same potential.

The cathode K of the transfer thyristor T1 and the emitter E of the coupling transistor Q1 are electrically connected to each other via the n-cathode layer 85. Likewise, the p-gate Gp of the transfer thyristor T1 and the base B of the coupling transistor Q1 are electrically connected to each other via the p-gate layer 86. The n-gate Gn of the transfer thyristor T1 and the collectors Cf and Cs of the coupling transistor Q1 form the n-gate layer 87, but they are separated from each other. The other transfer thyristors T and coupling transistors Q are formed in a similar manner.

Fig. 10A is a plan view illustrating an example of the layout of the light-emitting chip 40 according to the third exemplary embodiment. Fig. 10B is a sectional view taken along line XB-XB in Fig. 10A. In Figs. 10A and 10B, a protection layer (protection layer 90 in Fig. 4) and a light-shielding layer (light-shielding layer 95 in Fig. 4) are not shown. In Fig. 10B, the interconnection lines illustrated in Fig. 10A are not shown.

In Fig. 10A, the transfer thyristors T1 through T4, coupling transistors Q1 through Q4, setting thyristors S1 through S4, and VCSEL1 through VCSEL4 shown in Fig. 8 are primarily shown. In Fig. 10B, a cross section of the setting thyristor S1, VCSEL1, transfer thyristor T1, coupling transistor Q1, coupling resistor Rc connected to the coupling transistor Q1, and power supply line resistor Rg is shown.

As illustrated in Fig. 10B, in the light-emitting chip 40, on the n-type substrate 80, the n-cathode (DBR) layer 81, light-emitting layer 82, p-anode (DBR) layer 83, tunnel junction layer 84, n-cathode layer 85, p-gate layer 86, n-gate layer 87, and p-anode layer 88 are stacked on each other. Elements, such as the transfer thyristors T, coupling transistors Q, setting thyristors S, and VCSELs, are formed by islands separated from each other by removing some of the semiconductor layers by etching. Islands (islands 300 and 361 through 367) will be explained below by primarily referring to certain islands, such as the island 361 in which the setting thyristor S1 and the VCSEL1 are disposed and the island 362 in which the transfer thyristor T1 and the coupling transistor Q1 are disposed.

Like the island 300 in the light-emitting chip 10, the island 300 is a region in which the transfer section 12 (see Fig. 8), such as the transfer thyristor T1 and the coupling transistor Q1, is disposed. In the island 300, the n-cathode (DBR) layer 81, light-emitting layer 82, and p-anode (DBR) layer 83 are not removed but remain on the substrate 80.

In the island 361, the VCSEL1 and the setting thyristor S1 are stacked on each other. In the island 362, the transfer thyristor T1 and the coupling transistor Q1 shown in Fig. 9B are disposed. In the island 363, the current limiting resistor RL is disposed. In the island 364, the power supply line resistor Rg and the coupling resistor Rc are disposed. In the island 365, the power supply line resistor Rg and the start resistor Rs are disposed. In the island 366, the current limiting resistor R1 is disposed. In the island 367, the current limiting resistor R2 is disposed.

The layout and the cross section of the light-emitting chip 40 will be described below with reference to Figs. 10A and 10B.

The p-anode layer 88, n-gate layer 87, p-gate layer 86, n-cathode layer 85, tunnel junction layer 84, and p-anode (DBR) layer 83 around the island 301 are removed by etching. A p-ohmic electrode 381, which readily forms an ohmic contact with a p-type semiconductor layer, is disposed on the p-anode layer 88. An n-ohmic electrode 391, which readily forms an ohmic contact with an n-type semiconductor layer, is disposed on the n-gate layer 87 exposed by removing the p-anode layer 88. The VCSEL1 uses the n-cathode (DBR) layer 81 as the cathode K (see Fig. 9A), the light-emitting layer 82 as a light-emitting layer, and the p-anode (DBR) layer 83 as the anode A. The setting thyristor S1 uses the n-cathode layer 85 as the cathode K, the p-gate layer 86 as the p-gate Gp, the n-gate layer 87 as the n-gate Gn, and the p-anode layer 88 as the anode A. The n-ohmic electrode 391 is used as the electrode of the n-gate Gn (n-gate Gn electrode) of the setting thyristor S1. The n-ohmic electrode 391 may also be referred to as the n-gate Gn.

As shown in Fig. 10B, the VCSEL1 is disposed on the substrate 80, and the setting thyristor S1 is disposed on the VCSEL1 with the tunnel junction layer 84 interposed therebetween. The tunnel junction layer 84 suppresses the reduction in current flow through the p-anode (DBR) layer 83 of the VCSEL1 and the n-cathode layer 85 of the setting thyristor S, which would occur when the p-anode (DBR) layer 83 and the n-cathode layer 85 are reverse-biased.

The island 361 is formed cylindrically, except for a region in which the n-ohmic electrode 391 is provided. The p-ohmic electrode 381, which is formed in a ring-like shape, is disposed on the p-anode layer 88 of the cylindrical island 361. Part of the semiconductor layer forming the p-anode (DBR) layer 83, which is exposed by etching, is oxidized from the peripheral portion of the p-anode (DBR) layer 83 and serves as a current blocking region β in which a current does not readily flow circularly. In contrast, the central portion of the p-anode (DBR) layer 83, which is not exposed by etching, forms a current passing region α in which a current readily flows. The current passing region α and the current blocking region β are similar to those of the light-emitting chip 10.

The p-anode layer 88, n-gate layer 87, p-gate layer 86, n-cathode layer 85, and tunnel junction layer 84 around the island 362 are removed by etching (see Fig. 9B). A p-ohmic electrode 382 is disposed on the p-anode layer 88. The p-ohmic electrode 382 is an electrode (anode A electrode), which is connected to the anode A of the transfer thyristor T1, and is connected to the first transfer signal line 72 to which the first transfer signal φ1 is supplied. On the n-gate layer 87 exposed by removing the p-anode layer 88, n-ohmic electrodes 392, 393, and 394 are disposed. The n-ohmic electrode 392 is an electrode (collector Cs electrode) connected to the collector Cs of the coupling transistor Q1. The n-ohmic electrode 394 is an electrode (collector Cf electrode) connected to the collector Cf of the coupling transistor Q1. The n-gate layer 87 between the p-ohmic electrode 382 and the n-ohmic electrodes 392 and 394 is removed (see Fig. 9B). The n-ohmic electrode 393 is an electrode (n-gate Gn electrode) connected to the n-gate Gn of the transfer thyristor T1.

The p-anode layer 88, n-gate layer 87, p-gate layer 86, n-cathode layer 85, and tunnel junction layer 84 around the island 364 are removed by etching. Three n-ohmic electrodes 397, 398, and 399 are disposed on the n-gate layer 87 exposed by removing the p-anode layer 88. The n-gate layer 87 between the n-ohmic electrodes 397 and 398 serves as the coupling resistor Rc, while the n-gate layer 87 between the n-ohmic electrodes 398 and 399 serves as the power supply line resistor Rg.

The island 363, which is not shown in Fig. 10B, is formed similarly to the island 364. In the island 363, two n-ohmic electrodes 395 and 396 are disposed on the exposed n-gate layer 87. The n-gate layer 87 between the two n-ohmic electrodes 395 and 396 serves as the current limiting resistor RL.

The island 365, which is not shown in Fig. 10B, is formed similarly to the island 364. The start resistor Rs and the power supply line resistor Rg are disposed in the island 365. The islands 366 and 367, which are not shown in Fig. 10B, are formed similarly to the island 363. The current limiting resistors R1 and R2 are respectively disposed in the islands 366 and 367.

A p-ohmic electrode 341 is disposed on the exposed p-anode (DBR) layer 83 in the island 300. In the light-emitting chip 40, the portion along the outer periphery of the light-emitting chip 40 serves as a groove 350 that is formed by mesa etching down to the p-anode (DBR) layer 83. The portion around the island 361 is also removed by mesa etching to such a degree as to expose the p-anode (DBR) layer 83. Accordingly, the portion around the island 361 can also be regarded as the groove 350. The groove 350 is similar to that of the light-emitting chip 20 shown in Figs. 6A and 6B. The transfer section 12 of the light-emitting chip 40 is surrounded by the groove 350.

The back-side electrode 91 is disposed on the back side of the n-type substrate 80.

The connection relationship between the elements and lines in the light-emitting chip 40 will be discussed below. In Fig. 10A, interconnection lines (power supply line 71, first and second transfer signal lines 72 and 73, reference potential line 74, and light-emission signal line 75) are indicated by the thick solid lines.

The p-ohmic electrode 381 in the island 361, which is the anode A electrode of the setting thyristor S1, is connected to the light-emission signal line 75 to which the light-emission signal φI is supplied. The n-ohmic electrode 391 in the island 361, which is the n-gate Gn electrode of the setting thyristor S1, is connected to the n-ohmic electrode 392 in the island 362, which is the collector Cs electrode of the coupling transistor Q1. The n-ohmic electrode 392 is connected to the n-ohmic electrode 396 corresponding to the current limiting resistor RL in the island 363. The n-ohmic electrode 395 in the island 363 is connected to the light-emission signal line 75.

The p-ohmic electrode 382 in the island 362, which is the anode A electrode of the transfer thyristor T1, is connected to the first transfer signal line 72. The first transfer signal line 72 is connected, via the current limiting resistor R1 in the island 366, to the φ1 terminal to which the first transfer signal φ1 is supplied. The n-ohmic electrode 393 in the island 362, which is the n-gate Gn electrode of the transfer thyristor T1, is connected to an n-ohmic electrode in the island 365, which is a node between the power supply line resistor Rg and the start resistor Rs. The n-ohmic electrode 394 in the island 362, which is the collector Cf electrode of the coupling transistor Q1, is connected to the n-ohmic electrode 397 in the island 364, which is one of the n-ohmic electrodes corresponding to the coupling resistor Rc.

The n-ohmic electrode 398 in the island 364, which is the other one of the n-ohmic electrodes corresponding to the coupling resistor Rc, is connected to an n-ohmic electrode, which is the n-gate Gn electrode of the transfer thyristor T2. The n-ohmic electrode 399 in the island 364, which is the other one of the n-ohmic electrodes corresponding to the power supply line resistor Rg, is connected to the power supply line 71 to which the power supply potential Vga is supplied.

One of the n-ohmic electrodes corresponding to the start resistor Rs in the island 365 is connected to the second transfer signal line 73. The other one of the n-ohmic electrodes corresponding to the power supply line resistor Rg in the island 365 is connected to the power supply line 71. The second transfer signal line 73 is connected, via the current limiting resistor R2 in the island 367, to the φ2 terminal to which the second transfer signal φ2 is supplied.

The first transfer signal line 72 is connected to the p-ohmic electrodes, which are the anode A electrodes of the odd-numbered transfer thyristors T. The second transfer signal line 73 is connected to the p-ohmic electrodes, which are the anode A electrodes of the even-numbered transfer thyristors T.

The other transfer thyristors T, coupling transistors Q, setting thyristors S, and VCSELs are formed similarly to the transfer thyristor T1, coupling transistor Q1, setting thyristor S1, and VCSEL1, respectively.

The p-ohmic electrode 341 on the exposed p-anode (DBR) layer 83 in the island 300 is connected to the reference potential line 74. The reference potential line 74 is connected to the Vst terminal to which the reference potential Vst is supplied. Instead of providing the reference potential line 74 and the Vst terminal, the p-ohmic electrode 341 may be used as the Vst terminal or the reference potential terminal 341. Hereinafter, the Vst terminal will be referred to as the reference potential terminal 341. The reference potential terminal 341 is another example of the reference potential terminal.

The back-side electrode 91 on the back side of the n-type substrate 80 is the Vsub terminal to which the substrate potential Vsub is supplied.

The transfer section 12 including the transfer thyristors T, the coupling transistors Q, and other elements is disposed on the underlying diodes UD that are constituted by the p-anode (DBR) layer 83, light-emitting layer 82, and n-cathode (DBR) layer 81 like the VCSELs, which are light-emitting elements. The underlying diode UD will be referred to as a structure equivalent to a light-emitting element. The p-anode (DBR) layer 83 and the n-cathode (DBR) layer 81 of this structure form a pn junction. This pn junction electrically isolates the substrate potential Vsub of the substrate 80 (including the back-side electrode 91 and the n-cathode (DBR) layer 81) from the reference potential terminal 341 that supplies the reference potential Vst to the transfer section 12.

As described above, the light-emitting chip 40 is disposed on the substrate 80 formed of a single semiconductor. In the third exemplary embodiment, the light-emitting chip 40 is illustrated as a cathode-common circuit, but it may be formed as an anode-common circuit. In a cathode-common circuit, an n-type substrate is used, whereas, in an anode-common circuit, a p-type substrate is used. In the anode-common configuration, the n-type and p-type layers and electrodes in the third exemplary embodiment are arranged with their polarities reversed.

### [Fourth Exemplary Embodiment]

The light-emitting chips 10, 20, 30, and 40 have been described in the first through third exemplary embodiments.

In a fourth exemplary embodiment, a method for operating the light-emitting chips 10 through 40 will be discussed below. The light-emitting chip 20 is a modified example of the light-emitting chip 10. The light-emitting chip 30 is obtained by reversing the polarities of the potentials in the light-emitting chip 10, and thus can be operated by applying the potentials with the reversed polarities. The light-emitting chip 40 is different from the light-emitting chip 10 only in that the diodes (coupling elements) each used for coupling two adjacent transfer thyristors T in the light-emitting chip 10 are replaced by transistors (coupling elements), and thus can be operated similarly to the light-emitting chip 10. Accordingly, the method for operating the light-emitting chip 10 will be described below.

In the equivalent circuit diagram of the light source device 1 shown in Fig. 2, the substrate potential Vsub and the reference potential Vst are set to the ground potential GND (0 V), and the power supply potential Vga is set to "H" (5 V). The first and second transfer signals φ1 and φ2 and the light-emission signal φI are set to signals that can take "H" (5 V) and "L" (0 V). Then, a voltage at a maximum of 5 V (corresponding to "H" (5 V)) is applied to the series-connected VCSEL and setting thyristor S. Likewise, a voltage at a maximum of 5 V (corresponding to "H" (5 V)) is applied to the transfer thyristor T. As discussed above, the transfer thyristor T is operated similarly to the setting thyristor S. Accordingly, the voltage applied to the transfer thyristor is 5 V or lower. If the reference voltage Vst is set to 1 V, for example, the voltage applied to the transfer thyristor T is reduced to 4 V. This can make it less likely to apply an excessive current (overcurrent) to the transfer thyristor T.

The reference potential Vst is applied to the reference potential terminal 340 shown in Fig. 3B. The reference potential terminal 340 is connected to the p-anode (DBR) layer 83 in the transfer section 12. The n-cathode (DBR) layer 81 is disposed under the p-anode (DBR) layer 83 with the light-emitting layer 82 therebetween. The p-anode (DBR) layer 83 and the n-cathode (DBR) layer 81 form a pn junction. The n-cathode (DBR) layer 81 is set at the substrate potential Vsub via the n-type substrate 80 and the back-side electrode 91. When the substrate potential Vsub is set to the ground potential GND (0 V) and the reference potential Vst is set to 1 V, the p-anode (DBR) layer 83 and the n-cathode (DBR) layer 81 are forward-biased. However, the reference potential Vst (1 V) is lower than the forward voltage Vd (1.5 V) of the pn junction, thereby preventing a current from flowing between the p-anode (DBR) layer 83 and the n-cathode (DBR) layer 81. Even if a leakage current is likely to occur on the side surface P, which is a dicing surface, of the light-emitting chip 10, the groove 350 formed by removing the p-anode (DBR) layer 83 can suppress the flowing of a leakage current passing through the side surface P of the light-emitting chip 10 to the reference potential terminal 340 of the transfer section 12. As described above, current flow from the n-cathode (DBR) layer 81 to the p-anode (DBR) layer 83 in the transfer section 12 via the pn junction is also suppressed. If the voltage applied to the reference potential Vst is higher than or equal to the forward voltage Vd (1.5 V) of the pn junction, a current flows from the n-cathode (DBR) layer 81 to the p-anode (DBR) layer 83 in the transfer section 12. It is thus appropriate to set the voltage to be applied to the reference potential Vst to be lower than the forward voltage Vd (1.5 V) of the pn junction.

Next, a method for operating the light-emitting chip 10 in a low-side drive configuration will be described. In the low-side drive configuration, elements, such as MOS transistors, are placed on the downstream side of light-emitting elements in the current path. The low-side drive configuration is suitable for driving the light-emitting elements at higher speed.

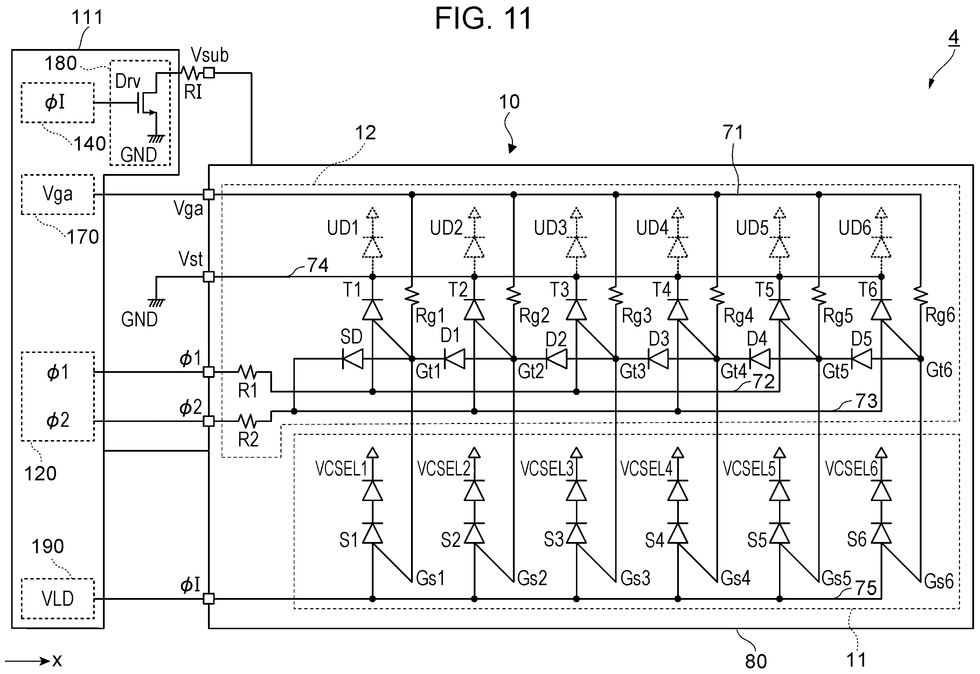

Fig. 11 is an equivalent circuit diagram of a light source device 4 according to the fourth exemplary embodiment. In Fig. 11, the rightward direction in the drawing is taken as the +x direction. The measurement apparatus 100 using the light source device 4 is similar to the measurement apparatus 100 in the first exemplary embodiment.

The light source device 4 illustrated in Fig. 11 includes a light-emitting chip 10 and a controller 111. The light-emitting chip 10 is identical to that in the first exemplary embodiment. The controller 111 is partly different from the controller 110 described in the first exemplary embodiment. Hereinafter, only portions that differ from the first exemplary embodiment will be described, while portions that are similar to those in the first exemplary embodiment are designated by like reference numerals and a detailed description thereof is omitted.

### (Controller 111)

The controller 111 includes a transfer signal generator 120, a light-emission signal generator 140, a power supply potential supplier 170, a driver unit 180, and a light-emission potential supplier 190.

The transfer signal generator 120 generates a first transfer signal φ1 and a second transfer signal φ2 for sequentially propagating the ON state among multiple transfer thyristors T in a transfer section 12, which will be discussed later. The light-emission signal generator 140 generates a light-emission signal φI for supplying a current that causes VCSELs, which will be discussed later, to turn ON (emit light). The power supply potential supplier 170 supplies a power supply potential Vga. The driver unit 180 controls the light-emission current in accordance with the light-emission signal φI. The light-emission potential supplier 190 supplies a light-emission potential VLD.

The driver unit 180 includes a driver Drv. As the driver element of the driver Drv, an NMOS transistor, for example, is used. The driver Drv is turned ON/OFF by the light-emission signal φI applied to the gate of the NMOS transistor. The source of the NMOS transistor is grounded at the ground potential GND (0 V). The drain of the NMOS transistor is connected to the Vsub terminal of the light-emitting chip 10 via the current limiting resistor RI. When the driver Drv turns ON, it supplies the ground potential GND (0 V) to the Vsub terminal of the light-emitting chip 10. The light-emission signal φI alternates between "H" (5 V) and "L" (0 V). The driver Drv turns ON when the light-emission signal φI is "H" (5 V) and is turned OFF when light-emission signal φI is "L" (0 V). The source of the driver Drv corresponds to one end thereof, while the drain of the driver Drv corresponds to another end thereof.

The light-emission potential supplier 190 supplies a light-emission potential VLD to the φI terminal of the light-emitting chip 10. The light-emission potential VLD is 5 V ("H" (5 V)), for example. That is, in the light source device 4, instead of the light-emission signal φI, the light-emission potential VLD is supplied to the φI terminal. The VCSEL and the setting thyristor S are series-connected. The light-emission potential VLD is applied to the anode of the setting thyristor S.

The Vst terminal to which the reference potential Vst is supplied is grounded at the ground potential GND (0 V).

The operation of the light source device 4 will be described below.

The light-emission signal φI is set to "L" (0 V). The driver Drv is OFF, and thus, the Vsub terminal is not at the ground potential GND (0 V).

The operation of the transfer unit 12 of the light-emitting chip 10 is similar to that in the first exemplary embodiment. When the transfer thyristor T turns ON, the potential at the gate Gt of the transfer thyristor T becomes "L" (0 V). The potential of the gate Gs of the setting thyristor S connected to the gate Gt of the transfer thyristor T also goes to "L" (0 V). The threshold voltage of the setting thyristor S shifts to 1.5 V. At this time, the driver Drv is OFF, and a current does not flow through the series-connected VCSEL and setting thyristor S.

When the light-emission signal φI shifts to "H" (5 V), the driver Drv turns ON and the Sub terminal goes to the ground potential GND (0 V). Then, the setting thyristor S turns ON, and the VCSEL connected in series with the setting thyristor S turns ON.

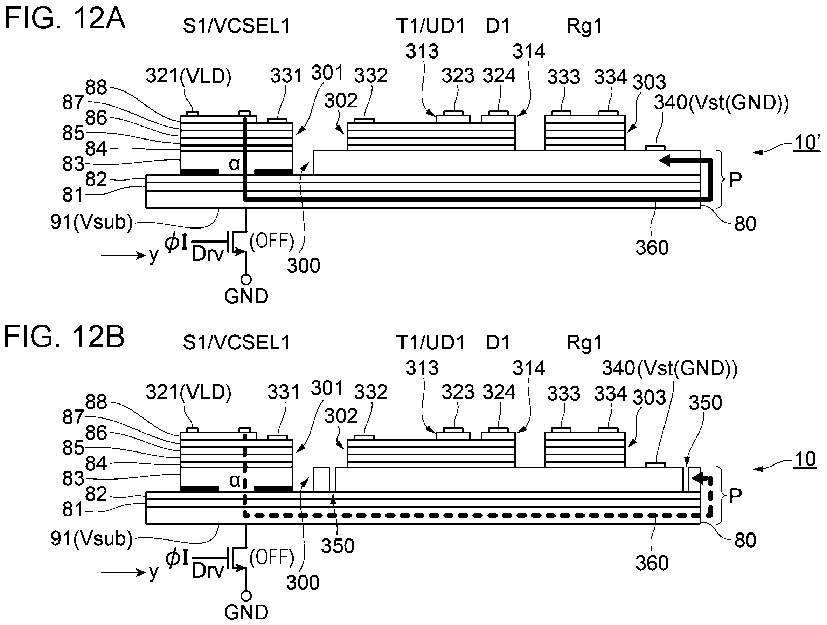

Figs. 12A and 12B are sectional views for explaining a leakage current in the light source device 4 of the fourth exemplary embodiment. Fig. 12A is a sectional view of a light-emitting chip 10' without a groove 350. Fig. 12B is a sectional view of the light-emitting chip 10 with a groove 350. The horizontal direction in Figs. 12A and 12B corresponds to the +y direction in Fig. 3A. The sectional view of Fig. 12A is the same as that of Fig. 5A. The sectional view of Fig. 12B is the same as that of Fig. 5B.

A description will be given of a case in which the light-emitting chip 10' shown in Fig. 12A is used. In Fig. 12A, the state in which the driver Drv has been switched from ON to OFF (indicated as "OFF" in Fig. 12A) is shown.

In the light source device 4, the substrate 80 (back-side electrode 91) of the light-emitting chip 10' is grounded (GND (0 V)) by the driver Drv. When the driver Drv is ON (light-emission signal φI is at "H" (5 V)), the setting thyristor S turns ON, and a current flows through the series-connected setting thyristor S and the VCSEL. The current flows from the p-ohmic electrode 321 to the substrate 80 and the back-side electrode 91 and then flows to ground (GND (0 V)) via the driver Drv.

When the side surface P of the light-emitting chip 10' has dicing-induced damage, a current passes through the inside of the substrate 80 and flows to the side surface P and further flows along the side surface P to the p-anode (DBR) layer 83 in the transfer section 12. The p-anode (DBR) layer 83 in the transfer section 12 is grounded (GND (0 V)) via the reference potential terminal 340. When the driver Drv is ON, two current paths are formed. One path is a normal path in which a current flows from the p-ohmic electrode 321, which is set at the light-emission potential VLD, passes through the setting thyristor S, the VCSEL, and the substrate 80, and flow to ground (GND (0 V)) via the driver Drv. The other path is a leakage current path (leakage current path 360) in which a current flows from the p-ohmic electrode 321, which is set at the light-emission potential VLD, passes through the setting thyristor S, the VCSEL, and the substrate 80, flows along the side surface P of the light-emitting chip 10', and reaches the reference potential terminal 340 at the ground potential GND (0 V)).

When the driver Drv is switched from ON to OFF, the current flowing through the normal path is interrupted. However, the current flowing through the leakage current path 360 is not interrupted but continues to flow. If the leakage current can maintain the ON state of the VCSEL, the VCSEL continues to emit light. Even when the leakage current is not capable of maintaining the ON state of the VCSEL, if the ON state of the setting thyristor S is maintained, the VCSEL connected to the setting thyristor S that remains ON will emit light together with another VCSEL when this VCSEL turns ON. That is, a false turn-on occurs.

A description will now be given of a case in which the light-emitting chip 10 shown in Fig. 12B is used. In Fig. 12B, the state in which the driver Drv has been switched from ON to OFF (indicated as "OFF" in Fig. 12A) is shown.

In the case of the use of the light-emitting chip 10 provided with the groove 350, when the driver Drv is ON, a current flows in the normal path in the same manner as in the light-emitting chip 10'. More specifically, a current flows from the p-ohmic electrode 321, passes through the setting thyristor S, the VCSEL, and the substrate 80, and flows to ground (GND (0 V)) via the driver Drv. Unlike the case in Fig. 12A, however, a current in the leakage current path 360 is interrupted by the groove 350 and does not reach the p-anode (DBR) layer 83 that is set at the ground potential GND (0 V) by the reference potential terminal 340. More specifically, a current flowing from the p-ohmic electrode 321, passing through the setting thyristor S, the VCSEL, and the substrate 80, and flowing along the side surface P of the light-emitting chip 10 does not reach the reference potential terminal 340, which is set at the ground potential GND (0 V)) by the reference potential terminal 340. In the light-emitting chip 10 provided with the groove 350, even if the side surface P of the light-emitting chip 10 has dicing-induced damage, the groove 350 provided in the island 300 prevents the formation of the leakage current path 360. Accordingly, the leakage current path 360 is indicated by the broken lines in Fig. 12B. The VCSEL that has turned ON can stop emitting light when the driver Drv turns OFF. The leakage current does not maintain the ON state of the setting thyristor S.

As discussed above, the p-anode (DBR) layer 83 and the n-cathode (DBR) layer 81 in the transfer section 12 form a pn junction. The p-anode (DBR) layer 83 is held at the ground potential GND (0 V) via the reference potential terminal 340. The n-cathode (DBR) layer 81 is at the same potential as the substrate 80 (including the back-side electrode 91) and is grounded (GND (0 V)) via the driver Drv. Because the n-cathode (DBR) layer 81 is grounded via the driver Drv, its potential does not necessarily fall exactly to 0 V and remains at least slightly positive. Accordingly, the pn junction between the p-anode (DBR) layer 83 and the n-cathode (DBR) layer 81 is reverse-biased. The region in the transfer section 12 (p-anode (DBR) layer 83 in the island 300) to which the reference potential terminal 340 is connected is electrically isolated from the substrate 80 (including the back-side electrode 91).

By using the light-emitting chip 10 in which the groove 350 is formed in the island 300 including the transfer section 12, the formation of the leakage current path 360 is suppressed in the light source device 4 in which the light-emitting chip 10 operates in the low-side drive configuration. As a result, the occurrence of false turn-on is reduced.

The reference potential terminal 340 in the first and second exemplary embodiments and the reference potential terminal 341 in the third exemplary embodiment may be set to a potential other than the ground potential GND (0 V).

In the first through fourth exemplary embodiments, the transfer section 12 has been described as an example of the drive unit. In the transfer sections 12 shown in Figs. 2, 7, and 8, the coupling diodes D are used. In the transfer section 12 shown in Fig. 8, the coupling transistors Q are used. These coupling elements are not limited to the coupling diodes D or the coupling transistors Q, and other elements, such as resistors and thyristors, may be used. Although the gate Gt of the transfer thyristor T and the gate Gs of the setting thyristor S are directly connected in the first through fourth exemplary embodiments, they may be connected via another element, such as a diode or a resistor.

In the first through fourth exemplary embodiments, the transfer section 12 is used as an example of the drive unit that propagates the ON state among transfer elements in their arrangement order. However, the drive unit is not limited to the one that propagates the ON state in this manner. Any drive unit may be used as long as it can individually select the light-emitting element to turn ON.

By providing the isolator that suppresses extension of the drive unit to the outer periphery of the light-emitting chip, the substrate potential Vsub to be supplied to the light-emitting elements and the reference potential Vst for the drive unit, which is provided on the structure equivalent to the light-emitting element, can be set to different from each other. Such an isolator is effective when circuits based on different potentials are to be formed on a single semiconductor substrate.

### (Appendix)

(((1))) A light-emitting device comprising:
   a substrate;
   a plurality of light-emitting elements disposed on the substrate;
   a plurality of thyristors configured to enter an ON state so as to cause the corresponding light-emitting elements to emit light or to increase an amount of light emission of the corresponding light-emitting elements;
   a drive unit that is disposed on the substrate and individually drives the plurality of thyristors so as to bring each of the plurality of thyristors into an ON state; and
   a reference potential terminal that supplies a predetermined reference potential to the drive unit, a region in the drive unit connected to the reference potential terminal being electrically isolated from a side surface of the substrate.
(((2))) A light-emitting chip comprising:
   a semiconductor substrate;
   a plurality of light-emitting elements and a plurality of thyristors, the plurality of light-emitting elements being disposed on a surface of the semiconductor substrate, the plurality of thyristors being configured to enter an ON state so as to cause the corresponding light-emitting elements to emit light or to increase an amount of light emission of the corresponding light-emitting elements;
   a drive unit that is disposed on the surface of the semiconductor substrate and individually drives the plurality of thyristors so as to bring each of the plurality of thyristors into an ON state;
   a reference potential terminal that supplies a predetermined reference potential to the drive unit; and
   an isolator that suppresses a current flow between the reference potential terminal and the semiconductor substrate.
(((3))) The light-emitting chip according to (((2))), wherein the isolator suppresses extension of the drive unit to an outer periphery of the semiconductor substrate.
(((4))) The light-emitting chip according to (((2))), wherein the isolator suppresses formation of a current path via a side surface of the semiconductor substrate between the light-emitting elements and the reference potential terminal.
(((5))) The light-emitting chip according to (((2))), wherein:
   the thyristors are stacked on the light-emitting elements disposed on the surface of the semiconductor substrate; and
   the drive unit is stacked on a structure equivalent to the light-emitting elements, the structure equivalent to the light-emitting elements being disposed on the semiconductor substrate.
(((6))) The light-emitting chip according to (((5))), wherein:
   the light-emitting elements, the thyristors, and the drive unit are constituted by a semiconductor multilayer body including a plurality of stacked semiconductor layers having different conductivity types; and
   the isolator is a groove provided in the semiconductor multilayer body or is a region in which insulating ions are implanted into the semiconductor multilayer body.
(((7))) The light-emitting chip according to (((6))), wherein:
   the light-emitting elements and the structure equivalent to the light-emitting elements each have a diode structure in which a p-type semiconductor layer, which serves as an anode, and an n-type semiconductor layer, which serves as a cathode, are stacked on each other; and
   the groove or the region in which the insulating ions are implanted at least extends from the surface of the semiconductor substrate to one of the p-type semiconductor layer and the n-type semiconductor layer that is farther from the semiconductor substrate.
(((8))) The light-emitting chip according to (((6))) or (((7))), wherein:
   the light-emitting elements include a current confinement layer, the current confinement layer serving as an oxidized region in which a current does not readily flow; and
   the groove has a depth reaching the current confinement layer.
(((9))) The light-emitting chip according to (((5))), wherein:
   the structure equivalent to the light-emitting elements has a diode structure in which a p-type semiconductor layer, which serves as an anode, and an n-type semiconductor layer, which serves as a cathode, are stacked on each other; and
   the reference potential is applied to one of the p-type semiconductor layer and the n-type semiconductor layer that is farther from the semiconductor substrate.
(((10))) The light-emitting chip according to (((6))), wherein the groove or the region in which the insulating ions are implanted is disposed to surround the drive unit.
(((11))) The light-emitting chip according to (((2))), wherein the drive unit sequentially propagates the ON state among the plurality of thyristors.
(((12))) A light-emitting chip comprising:
   a semiconductor substrate;
   a plurality of light-emitting elements and a plurality of thyristors, the plurality of light-emitting elements being disposed on a surface of the semiconductor substrate, the plurality of thyristors being stacked on the plurality of light-emitting elements, the plurality of thyristors being configured to enter an ON state so as to cause the corresponding light-emitting elements to emit light or to increase an amount of light emission of the corresponding light-emitting elements;
   a reference potential terminal that is disposed on a structure equivalent to the light-emitting elements, a predetermined reference potential being supplied to the reference potential terminal; and
   an isolator that suppresses formation of a current path via a side surface of the semiconductor substrate between the light-emitting elements and the reference potential terminal.
(((13))) A light-emitting device comprising:
   the light-emitting chip according to one of (((2))) to (((12))); and
   a driver that is set at one end to a ground potential and is connected at another end to the semiconductor substrate of the light-emitting chip and that is configured to enter an ON state at a predetermined timing so as to cause a light-emission current to flow to the light-emitting element.
(((14))) A measurement apparatus comprising:
   the light-emitting device according to (((13))); and
   an acquisition unit that acquires information on a subject based on light emitted from the light-emitting device and reflected by the subject.

According to the light-emitting device of (((1))) and the light-emitting chips of (((2))) and (((12))), a false turn-on is less likely to occur than in the configuration in which a leakage current from the light-emitting element may flow to the reference potential terminal of the drive unit.

According to the light-emitting chip of (((3))), the side surface of the light-emitting chip becomes less vulnerable to dicing-induced damage than in the configuration in which the drive unit extends to the outer periphery of the semiconductor substrate.

According to the light-emitting chip of (((4))), dicing-induced damage can be accommodated.

According to the light-emitting chip of (((5))), the light-emitting elements of the light-emitting chip can be aligned with higher density than in the configuration in which the thyristors are not stacked on the light-emitting elements.

According to the light-emitting chip of (((6))), the drive unit and the dicing surface can be electrically isolated from each other.

According to the light-emitting chip of (((7))), the effect of electrically isolating the drive unit and the dicing surface from each other can be enhanced.

According to the light-emitting chip of (((8))), the isolator can be formed in the same process as in the formation of the current blocking region.

According to the light-emitting chip of (((9))), electrical isolation can be achieved by the pn junction.

According to the light-emitting chip of (((10))), the reference potential and the substrate potential can be isolated from each other more effectively than in the configuration in which the groove or the region in which the insulating ions are implanted does not surround the drive unit.

According to the light-emitting chip of (((11))), ON/OFF control for the light-emitting elements is facilitated compared with the configuration in which the ON state does not sequentially propagate among the thyristors.

According to the light-emitting device of (((13))), the light-emitting elements can be driven at higher speed than when the high-side drive configuration is employed.

According to (((14))), a measurement apparatus that can perform 3D measurement can be provided.

This application is based on Japanese Patent Application No. 2024-009051 filed January 24, 2024 and Japanese Patent Application No. 2024-226415 filed December 23, 2024.

## Claims

1. A light-emitting device comprising:
a substrate;
a plurality of light-emitting elements disposed on the substrate;
a plurality of thyristors configured to enter an ON state so as to cause the corresponding light-emitting elements to emit light or to increase an amount of light emission of the corresponding light-emitting elements;
a drive unit that is disposed on the substrate and individually drives the plurality of thyristors so as to bring each of the plurality of thyristors into an ON state; and
a reference potential terminal that supplies a predetermined reference potential to the drive unit, a region in the drive unit connected to the reference potential terminal being electrically isolated from a side surface of the substrate.

2. A light-emitting chip comprising:
a semiconductor substrate;
a plurality of light-emitting elements and a plurality of thyristors, the plurality of light-emitting elements being disposed on a surface of the semiconductor substrate, the plurality of thyristors being configured to enter an ON state so as to cause the corresponding light-emitting elements to emit light or to increase an amount of light emission of the corresponding light-emitting elements;
a drive unit that is disposed on the surface of the semiconductor substrate and individually drives the plurality of thyristors so as to bring each of the plurality of thyristors into an ON state;
a reference potential terminal that supplies a predetermined reference potential to the drive unit; and
an isolator that suppresses a current flow between the reference potential terminal and the semiconductor substrate.

3. The light-emitting chip according to claim 2, wherein the isolator suppresses extension of the drive unit to an outer periphery of the semiconductor substrate.

4. The light-emitting chip according to claim 2, wherein the isolator suppresses formation of a current path via a side surface of the semiconductor substrate between the light-emitting elements and the reference potential terminal.

5. The light-emitting chip according to claim 2, wherein:
the thyristors are stacked on the light-emitting elements disposed on the semiconductor substrate; and
the drive unit is stacked on a structure equivalent to the light-emitting elements, the structure equivalent to the light-emitting elements being disposed on the semiconductor substrate.

6. The light-emitting chip according to claim 5, wherein:
the light-emitting elements, the thyristors, and the drive unit are constituted by a semiconductor multilayer body including a plurality of stacked semiconductor layers having different conductivity types; and
the isolator is a groove provided in the semiconductor multilayer body or is a region in which insulating ions are implanted into the semiconductor multilayer body.

7. The light-emitting chip according to claim 6, wherein:
the light-emitting elements and the structure equivalent to the light-emitting elements each have a diode structure in which a p-type semiconductor layer, which serves as an anode, and an n-type semiconductor layer, which serves as a cathode, are stacked on each other; and
the groove or the region in which the insulating ions are implanted at least extends from the surface of the semiconductor substrate to one of the p-type semiconductor layer and the n-type semiconductor layer that is farther from the semiconductor substrate.

8. The light-emitting chip according to claim 6 or 7, wherein:
the light-emitting elements include a current confinement layer, the current confinement layer serving as an oxidized region in which a current does not readily flow; and
the groove has a depth reaching the current confinement layer.

9. The light-emitting chip according to claim 5, wherein:
the structure equivalent to the light-emitting elements has a diode structure in which a p-type semiconductor layer, which serves as an anode, and an n-type semiconductor layer, which serves as a cathode, are stacked on each other; and
the reference potential is applied to one of the p-type semiconductor layer and the n-type semiconductor layer that is farther from the semiconductor substrate.

10. The light-emitting chip according to claim 6, wherein the groove or the region in which the insulating ions are implanted is disposed to surround the drive unit.

11. The light-emitting chip according to claim 2, wherein the drive unit sequentially propagates the ON state among the plurality of thyristors.

12. A light-emitting chip comprising:
a semiconductor substrate;
a plurality of light-emitting elements and a plurality of thyristors, the plurality of light-emitting elements being disposed on a surface of the semiconductor substrate, the plurality of thyristors being stacked on the plurality of light-emitting elements, the plurality of thyristors being configured to enter an ON state so as to cause the corresponding light-emitting elements to emit light or to increase an amount of light emission of the corresponding light-emitting elements;
a reference potential terminal that is disposed on a structure equivalent to the light-emitting elements, a predetermined reference potential being supplied to the reference potential terminal; and
an isolator that suppresses formation of a current path via a side surface of the semiconductor substrate between the light-emitting elements and the reference potential terminal.

13. A light-emitting device comprising:
the light-emitting chip according to one of claims 2 to 12; and
a driver that is set at one end to a ground potential and is connected at another end to the semiconductor substrate of the light-emitting chip and that is configured to enter an ON state at a predetermined timing so as to cause a light-emission current to flow to the light-emitting element.

14. A measurement apparatus comprising:
the light-emitting device according to claim 13; and
an acquisition unit that acquires information on a subject based on light emitted from the light-emitting device and reflected by the subject.
